# EUROPEAN PATENT APPLICATION

(11) **EP 4 842 194 A2**
(43) Date of publication of application: **18.11.2026**
(21) Application number: 26207164.0
(22) Date of filing: 29.10.2024
(51) Int. Cl.: H10W 70/692

(54) **MICROELECTRONIC ASSEMBLIES WITH PRE-SINGULATION EDGE FEATURES IN GLASS CORES**

(30) Priority: 12.12.2023 US 202318536744
(62) Document number(s) of the earlier application(s) in accordance with Art. 76 EPC: 24209505.7 / 4 570 770
(71) Applicant: INTEL Corporation, Santa Clara, CA 95054 (US)
(72) Inventor: Shan, Bohan, Chandler, 85226 (US); Jones, Jesse C., Chandler, 85248 (US); Nie, Bai, Chandler, 85249 (US); Bryks, Whitney, Tempe, 85284 (US); Duong, Benjamin T., Phoenix, 85044 (US); Mishra, Pratyush, Tempe, 85283 (US); Ecton, Jeremy, Gilbert, 85298 (US); Li, Yuqin, Chandler, 85226 (US); Malatkar, Pramod, Chandler, 85226 (US); Singh, Yuvraj, Chandler, 85226 (US); Kornbluth, Yosef, Phoenix, 85014 (US); Palmer, Travis, San Diego, 92122 (US); Stacey, Joshua, Chandler, 85226 (US); Mohammadighaleni, Mahdi, Phoenix, 85048 (US); Marin, Brandon C., Gilbert, 85234 (US); Duan, Gang, Chandler, 85248 (US); Nad, Suddhasattwa, Chandler, 85249 (US); Pietambaram, Srinivas Venkata Ramanuja, Chandler, 85249 (US); Mohapatra, Pratyasha, Hillsboro, 97124 (US); Agarwal, Soham, Chandler, 85225 (US); Hernandez, Kari, Phoneix, 85028 (US); Sreeramagiri, Praveen, Gilbert, 85297 (US); Li, Yi, Chandler, 85225 (US); El Khatib, Ibrahim, Chandler, 85226 (US); Feng, Hongxia, Chandler, 85249 (US); Chen, Haobo, Chandler, 85249 (US); Tanaka, Hiroki, Gilbert, 85295 (US); Garelick, Aaron, Chandler, 85226 (US); Agraharam, Sairam, Chandler, 85286 (US); Manepalli, Rahul N., Chandler, 85249 (US); Mu, Bin, Tempe, 85284 (US); Waimin, Jose, Gilbert, 85295 (US); Carrazzone, Ryan, Chandler, 85226 (US); Xu, Dingying, Chandler, 85248 (US); Guo, Xiaoying, Chandler, 85248 (US); Liu, Xiao, Chandler, 85226 (US); Hu, Xiyu, Chandler, 85226 (US); Cao, Yi, Chandler, 85226 (US)
(74) Representative: Goddar, Heinz J.

(57) **Abstract**

Various techniques for alleviating crack formation and propagation in glass, and related devices and methods, are disclosed. The techniques are based on providing various edge features before singulation of a glass panel into individual glass units. In one aspect, an edge feature may be an opening in an edge region of a glass core, the opening extending from one of the faces of the glass core towards the opposite face of the glass core and comprising a fill material such as an insulator material, a polymer, or a conductive material. In another aspect, an edge feature may be an anchor comprising a first pad over one of the faces of a glass core, a second pad over the opposite face of the glass core, and a pin, wherein the pin is attached to the first pad and extends from the first pad into the glass core.

## Description

### Background

For the past several decades, scaling of features in integrated circuits (ICs) has been a driving force behind an ever-growing semiconductor industry and emerging applications in fields such as big data, artificial intelligence, mobile communications, and autonomous driving. Scaling to smaller and smaller features enables increased densities of functional units on the limited real estate of semiconductor chips. For example, shrinking transistor size allows incorporation of an increased number of memory or logic devices on a chip, lending to the fabrication of products with increased capacity. The drive for the ever-increasing capacity, however, is not without issue. The necessity to optimize fabrication and performance of each component (e.g., of each transistor) is becoming increasingly significant.

Parallel to optimizations at the transistor level, advanced IC packaging landscape is rapidly evolving to accommodate performance expectations and requirements of shrinking transistor size. Multiple IC dies are now commonly coupled together in a multi-die IC package to integrate features or functionality and to facilitate connections to other components, such as package substrates. For example, IC packages may include an embedded multi-die interconnect bridge (EMIB) for coupling two or more IC dies.

Integration of multiple dies in a single IC package has tremendous benefits but adds additional complexities due to placing materials with different material properties in close proximity to one another. When an IC package undergoes multiple processing steps involving various temperatures and pressure loads, individual materials within the package may behave differently from one another, resulting in out of plane deformation of various layers, known as "package warpage." One way to address package warpage is to use stiffer cores to which different IC dies are attached. Recently, glass cores have been explored as alternatives to organic resin-based cores (e.g., cores based on using Ajinomoto Build-up Film(ABF)). Glass is considered more rigid than organic resin-based materials and has several advantages such as excellent thermal properties, low coefficient of thermal expansion (CTE), high electrical insulation, chemical resistance, optical transparency, and compatibility with advances semiconductor properties. However, a major challenge for widespread adoption of glass cores is the fact that glass is highly susceptible to damage due to mechanical and/or thermal stresses.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a schematic side, cross-sectional view of one example microelectronic assembly, according to some embodiments of the present disclosure.
FIG. 2 is a schematic side, cross-sectional view of another example microelectronic assembly, according to some embodiments of the present disclosure.
FIG. 3 illustrates a glass panel during singulation.
FIGS. 4A-4B illustrate approximate locations of edge features in a glass core, according to some embodiments of the present disclosure.
FIGS. 5A-5D provide cross-sectional side views of glass cores illustrating a process of including edge features in the form of continuous trenches, according to some embodiments of the present disclosure.
FIG. 6 illustrates a glass panel with edge features in the form of continuous trenches in the edge regions of glass units, according to some embodiments of the present disclosure.
FIGS. 7A-7D provide cross-sectional side views of glass cores illustrating different cross-sectional shapes of edge features in the form of continuous trenches, according to some embodiments of the present disclosure.
FIG. 8 illustrates a glass panel with edge features in the form of discontinuous openings in the edge regions of glass units, according to some embodiments of the present disclosure.
FIGS. 9A-9B provide top-down views of glass cores illustrating different examples of edge features in the form of multiple rows of offset discontinuous openings, according to some embodiments of the present disclosure.
FIGS. 10A-10E provide top-down views of glass cores illustrating further examples of edge features in the form of multiple rows of discontinuous openings, according to some embodiments of the present disclosure.
FIG. 11 illustrates a glass panel with edge features in the form of discontinuous openings in the edge regions of glass units as well as in the edge regions of the glass panel, according to some embodiments of the present disclosure.
FIGS. 12A-12C provide cross-sectional side views of glass cores illustrating different examples of edge features in the form of openings filled with self-healing materials, according to some embodiments of the present disclosure.
FIGS. 13A-13B provide top-down views of glass cores illustrating different examples of edge features in the form of trenches filled with self-healing materials, according to some embodiments of the present disclosure.
FIGS. 14A-14B provide top-down views of glass cores illustrating different examples of edge features in the form of discontinuous openings along the saw streets, according to some embodiments of the present disclosure.
FIGS. 15A-15B provide top-down views of glass cores illustrating different examples of edge features in the form of continuous and discontinuous anchors in the edge regions, according to some embodiments of the present disclosure.
FIGS. 16A-16D provide cross-sectional side views of portions of glass cores illustrating different examples of edge features in the form of anchors in the edge regions, according to some embodiments of the present disclosure.
FIGS. 17A-17B provide top-down views of glass cores illustrating different examples of edge features in the form of continuous and discontinuous anchors extending through build-up layers, according to some embodiments of the present disclosure.
FIGS. 18A-18D provide cross-sectional side views of portions of glass cores illustrating different examples of edge features in the form of anchors extending through build-up layers, according to some embodiments of the present disclosure.
FIGS. 19A-19B provide top-down views of glass panels illustrating different examples of edge features in the form of daisy chain rings, according to some embodiments of the present disclosure.
FIGS. 20A-20C provide cross-sectional side views of portions of glass cores illustrating different examples of cross-sectional profiles of daisy chain rings, according to some embodiments of the present disclosure.
FIGS. 21A-21B provide top-down and cross-sectional side views of glass cores illustrating a first example of edge features in the form of edge clamps, according to some embodiments of the present disclosure.
FIGS. 22A-22B provide top-down and cross-sectional side views of glass cores illustrating a second example of edge features in the form of edge clamps, according to some embodiments of the present disclosure.
FIG. 23 is a top view of a wafer and dies that may be included in a microelectronic assembly with a glass core in accordance with any of the embodiments disclosed herein, according to some embodiments of the present disclosure.
FIG. 24 is a side, cross-sectional view of an IC device that may be included in a microelectronic assembly with a glass core in accordance with any of the embodiments disclosed herein, according to some embodiments of the present disclosure.
FIG. 25 is a side, cross-sectional view of an IC device assembly that may include a glass core in accordance with any of the embodiments disclosed herein, according to some embodiments of the present disclosure.
FIG. 26 is a block diagram of an example communication device that may include a microelectronic assembly with a glass core in accordance with any of the embodiments disclosed herein, according to some embodiments of the present disclosure.

### Detailed Description

As mentioned above, a major challenge for widespread adoption of glass cores is the fact that glass is highly susceptible to damage due to mechanical and/or thermal stresses. One source of mechanical and thermal stresses in glass is singulation process (sometimes referred to as "dicing" or "cutting") that takes place during manufacturing of glass cores. Singulation is a process in which a cutting tool (e.g., a glass cutter, a diamond blade, or a saw) applies mechanical force to the surface of a glass panel in order to separate (e.g., dice or cut) the panel into individual glass units having a smaller form factor than the panel. The mechanical force applied by the cutting tool may create a localized stress concentration (e.g., regions of higher stress) at or near the surfaces where the cutting tool contacts the glass, e.g., at or near the edges of the individual glass units, where, as used herein, the term "edge" refers to a side/sidewall that is between top and the bottom faces of a glass unit, a glass core, or glass panel. Because glass is a brittle material characterized by its lack of ductility (e.g., characterized by its limited ability to undergo significant plastic deformation before fracturing), localized stress concentration often leads to formation of cracks at the edges of singulated glass units. Besides imposing mechanical stress onto glass, singulation can also generate thermal stress due to friction between the cutting tool and glass, heating up the surface being cut. The heat can cause localized expansion and contraction of glass, further promoting crack formation and propagation.

Singulation is not the only source of stress and damage that may affect glass cores. Presence of materials with different CTEs on top and/or on the bottom of glass cores (e.g., metals of conductive pathways and/or dielectric materials of build-up layers) adds to the stresses in glass (such stresses referred to as "CTE mismatch-induced stresses"), further exacerbating the problem of crack formation. Even if cracks don't form immediately during singulation, cutting of brittle materials like glass often results in individual glass units with edges that are rough, jagged, or otherwise uneven. Repeated thermal cycling during operation of microelectronic assemblies that include glass cores with such edges can gradually weaken the glass surface due to CTE mismatch-induced stresses, leading to formation of cracks at that time. Furthermore, even before singulation, glass may have tiny surface flaws or defects, which can act as initiation points for crack formation, with additional mechanical and/or thermal stresses increasing the severity of crack growth.

Once cracks start to form, they tend to propagate through glass, with additional mechanical and/or thermal stresses increasing the severity of crack propagation. In particular, the stress concentration at the edges of the glass units encourages the cracks to extend further into glass, and the inherent brittleness of glass makes it particularly susceptible to crack propagation. Propagation of cracks may even cause a glass volume to split into two halves around a plane parallel to the top/bottom surfaces of the glass volume and being about in the middle of the glass volume, one half being the bottom half and the other half being the top half of what is supposed to be a single structure.

As the foregoing illustrates, crack formation and propagation in glass compromises the structural integrity of glass, making microelectronic assemblies with glass cores particularly prone to failure over time. Embodiments of the present disclosure relate to various techniques, as well as to related devices and methods, for alleviating (e.g., mitigating or reducing) crack formation and propagation in glass. In particular, embodiments of the present disclosure are based on providing various edge features before singulation of a glass panel into individual glass units. Hence, these edge features may be referred to as "pre-singulation" edge features but, for the sake of brevity, they are simply referred to herein as "edge features." The individual glass units can serve as glass cores of microelectronic assemblies, and the edge features can help mitigate or reduce crack formation and/or propagation in glass cores. As used herein, an "edge feature" refers to any feature located in a region at or near an edge of a glass core (e.g., of a glass unit after singulation). A region at or near an edge of a glass core is referred to herein as an "edge region" and is understood to be extending from the edge into the glass core by a distance that is less than about 10% (e.g., less than about 7% or less than about 5%) of the width of the glass core. In one aspect of the present disclosure, an edge feature may be an opening in an edge region of a glass core, the opening extending from one of the faces of the glass core towards the opposite face of the glass core and comprising a fill material such as an insulator material, a polymer, a conductive material, or ABF. In another aspect, an edge feature may be an anchor comprising a first pad over one of the faces of a glass core, a second pad over the opposite face of the glass core, and a pin, wherein the pin is attached to the first pad and extends from the first pad into the glass core. In yet another aspect, an edge feature may be a daisy chain structure embedded in a glass core proximate to an edge of the glass core, the daisy chain structure having first portions in recesses in one of the faces of the glass core and having second portions in recesses in the opposite face of the glass core. Still in another aspect, an edge feature may be a clamp structure around the edge, the clamp structure having a first portion at one of the faces of the glass core, a second portion at the opposite face, and a third portion wrapping around the edge, wherein the third portion is attached to the first portion and the second portion.

Integration of layers of different materials (e.g., multiple dies, redistribution layers, package substrates) in a single IC package or a microelectronic assembly is challenging due to package warpage, among others. Providing IC packages or microelectronic assemblies with glass cores having one or more edge features as described herein may help. Various ones of the embodiments disclosed herein may help achieve reliable integration of multiple layers of different materials within a single microelectronic assembly at a lower cost and/or with greater design flexibility, relative to conventional approaches. Various ones of the microelectronic assemblies disclosed herein may exhibit reduced warpage, relative to microelectronic assemblies without glass cores. The microelectronic assemblies disclosed herein may be particularly advantageous for small and low-profile applications in computers, tablets, industrial robots, and consumer electronics (e.g., wearable devices).

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

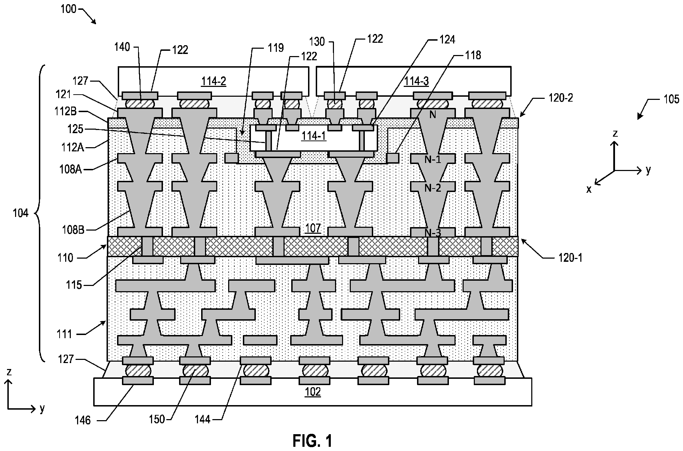

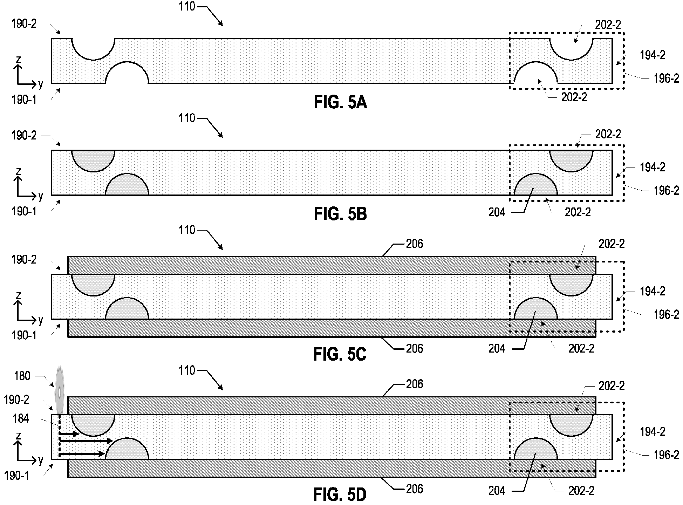

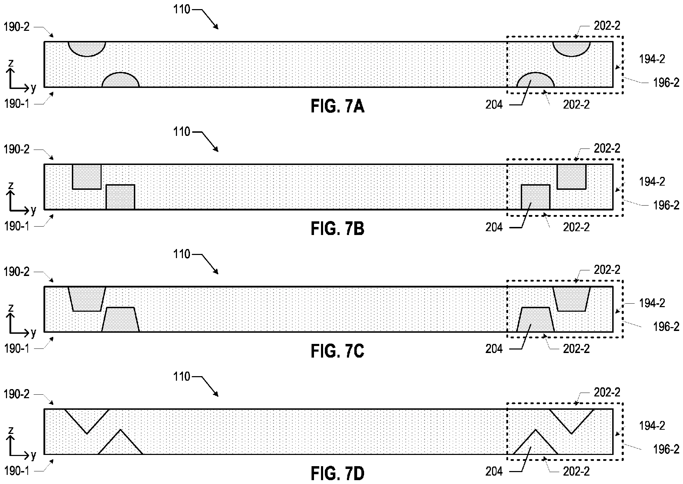

Any of the features discussed with reference to any of accompanying drawings herein may be combined with any other features to form a microelectronic assembly 100, a glass core 110, an IC device 1600, an IC device assembly 1700, or a communication device 1800, as appropriate. For convenience, the phrase "dies 114" may be used to refer to a collection of dies 114-1, 114-2, and so on, etc. A collection of drawings labeled with different letters may be referred to without the letters, e.g., a collection of FIGS. 5A-5D may be referred to as "FIG. 5," a collection of FIGS. 7A-7D may be referred to as "FIG. 7," etc. A number of elements of the drawings with same reference numerals may be shared between different drawings; for ease of discussion, a description of these elements provided with respect to one of the drawings is not repeated for the other drawings, and these elements may take the form of any of the embodiments disclosed herein. To not clutter the drawings, if multiple instances of certain elements are illustrated, only some of the elements may be labeled with a reference numeral (e.g., a plurality of conductive contacts 122 are shown in FIG. 1 but only one of the them is labeled with a reference numeral). Also to not clutter the drawings, not all reference numerals shown in one of the drawings are shown in other similar drawings.

The drawings are not necessarily to scale. Although many of the drawings illustrate rectilinear structures with flat walls and right-angle corners, this is simply for ease of illustration and may not reflect real-life process limitations which may cause various features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers. There may be other defects not listed here but that are common within the field of semiconductor device fabrication and packaging. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of a glass core with one or more edge features as described herein.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used to describe a range of dimensions, the phrase "between X and Y" represents a range that includes X and Y. When used to describe a location of an element, the phrase "between X and Y" represents a region that is spatially between element X and element Y. The terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 10%, e.g., within +/- 5% or within +/- 2%, of the exact orientation.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, the terms "package" and "IC package" are synonymous, as are the terms "die" and "IC die." Furthermore, the terms "chip," "chiplet," "die," and "IC die" may be used interchangeably herein.

Although certain elements may be referred to in the singular herein, such elements may include multiple sub-elements. For example, "a dielectric material" may include one or more dielectric materials or "an insulator material" may include one or more insulator materials. The terms "oxide," "carbide," "nitride," etc. refer to compounds containing, respectively, oxygen, carbon, nitrogen, etc. The term "high-k dielectric" refers to a material having a higher dielectric constant than silicon oxide, while the term "low-k dielectric" refers to a material having a lower dielectric constant than silicon oxide. The term "insulating" and variations thereof (e.g., "insulative" or "insulator") means "electrically insulating," the term "conducting" and variations thereof (e.g., "conductive" or "conductor") means "electrically conducting," unless otherwise specified. With reference to optical signals and/or devices, components and elements that operate on or using optical signals, the term "conducting" can also mean "optically conducting." The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

FIG. 1 is a schematic side, cross-sectional view of one example microelectronic assembly 100 in which a glass core with one or more edge features as described herein may be implemented, according to some embodiments of the present disclosure. The microelectronic assembly 100 may include a substrate 107 with a double-sided bridge die 114-1 in a cavity 119 in the substrate 107, the die 114-1 may be electrically coupled to a conductive pathway, e.g., a conductive trace 108A or a conductive via 108B, in a metal layer N-1 of the substrate 107 that is beneath a bottom of the cavity 119. The substrate 107 may include a dielectric material 112 (e.g., a first dielectric material layer 112A and a second dielectric material layer 112B, as shown, together referred to as "one or more layers of the dielectric material 112") and a conductive material 108 arranged in the one or more layers of the dielectric material 112 to provide conductive pathways (e.g., conductive traces 108A and conductive vias 108B) through the substrate 107, as well as to provide conductive pads and contacts. The substrate 107 may include a first surface 120-1 and an opposing second surface 120-2. The die 114-1 may be surrounded by the dielectric material 112 of the substrate 107. The die 114-1 may include a bottom face (e.g., the surface facing towards the first surface 120-1) with first conductive contacts 122, an opposing top face (e.g., the surface facing towards the second surface 120-2) with second conductive contacts 124, and through-silicon vias (TSVs) 125 coupling respective first and second conductive contacts 122, 124. In some embodiments, a pitch of the first conductive contacts 122 on the first die 114-1 maybe between 25 microns and 250 microns. As used herein, pitch is measured center-to-center (e.g., from a center of a conductive contact to a center of an adjacent conductive contact). In some embodiments, a pitch of the second conductive contacts 124 on the first die 114-1 maybe between 25 microns and 100 microns. The dies 114-2, 114-3 may include a set of conductive contacts 122 on the bottom face of the die (e.g., the surface facing towards the first surface 120-1). The die 114 may include other conductive pathways (e.g., including lines and vias) and/or to other circuitry (not shown) coupled to the respective conductive contacts (e.g., conductive contacts 122, 124) on the surface of the die 114. As used herein, the terms "die," "microelectronic component," and similar variations may be used interchangeably. As used herein, the terms "interconnect component," "bridge die," and similar variations may be used interchangeably. The bridge die 114-1 may be electrically coupled to dies 114-2, 114-3 by die-to-die (DTD) interconnects 130 at a second surface 120-2. In particular, conductive contacts 124 on a top face of the die 114-1 may be coupled to conductive contacts 122 on a bottom face of dies 114-2, 114-3 by conductive vias 108B through the second dielectric material layer 112B.

As used herein, a "conductive contact" may refer to a portion of conductive material (e.g., metal) serving as an electrical interface between different components (e.g., part of a conductive interconnect); conductive contacts may be recessed in, flush with, or extending away (e.g., having a pillar shape) from a surface of a component, and may take any suitable form (e.g., a conductive pad or socket, or portion of a conductive line or via). In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of a conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, conductive traces and vias may be referred to as "metal traces" and "metal vias", respectively, to highlight the fact that these elements include conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). Example structures that may be included in the dies 114 disclosed herein are discussed below with reference to the IC device 1600. The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked).

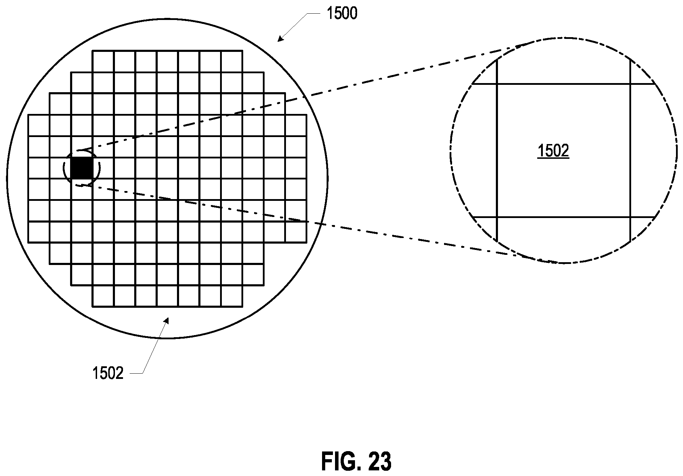

In some embodiments, the die 114 may include conductive pathways to route power, ground, and/or signals to/from other dies 114 included in the microelectronic assembly 100. For example, the die 114-1 may include TSVs 125, including a conductive via, such as a metal via, isolated from the surrounding silicon or other semiconductor material by a barrier oxide),or other conductive pathways through which power, ground, and/or signals may be transmitted between the package substrate 102 and one or more dies 114 "on top" of the die 114-1 (e.g., in the embodiment of FIG. 1, the dies 114-2 and/or 114-3). In some embodiments, the die 114-1 may not route power and/or ground to the dies 114-2 and 114-3; instead, the dies 114-2, 114-3 may couple directly to power and/or ground lines in the package substrate 102 by substrate-to-package substrate (STPS) interconnects 150, conductive pathways provided by the conductive material 108 in the substrate 107, and die-to-substrate (DTS) interconnects 140. In some embodiments, the die 114-1 may be thicker than the dies 114-2, 114-3. In some embodiments, the die 114-1 may be a memory device or a high frequency serializer and deserializer (SerDes), such as a Peripheral Component Interconnect (PCI) express. In some embodiments, the die 114-1 may be a processing die, a radio frequency chip, a power converter, a network processor, a workload accelerator, a voltage regulator die, or a security encryptor. In some embodiments, the die 114-2 and/or the die 114-3 may be a processing die, a radio frequency chip, a power converter, a network processor, a workload accelerator, a voltage regulator die, or a security encryptor. In some embodiments, the die 114 may be as described below with reference to the die 1502 of FIG. 23.

The dielectric material 112 of the substrate 107 may be formed in layers (e.g., at least a first dielectric material layer 112A and a second dielectric material layer 112B). In some embodiments, the dielectric material 112 may include an organic material, such as an organic build-up film. In some embodiments, the dielectric material 112 may include a ceramic, an epoxy film having filler particles therein, glass, an inorganic material, or combinations of organic and inorganic materials, for example. In some embodiments, the conductive material 108 may include a metal (e.g., copper). In some embodiments, the substrate 107 may include layers of dielectric material 112/conductive material 108, with lines/traces/pads/contacts (e.g., conductive traces 108A) of conductive material 108 in one layer electrically coupled to lines/traces/pads/contacts (e.g., conductive traces 108A) of conductive material 108 in an adjacent layer by vias (e.g., 108B) of the conductive material 108 extending through the dielectric material 112. Conductive traces 108A may be referred to herein as "conductive lines," "conductive elements," "conductive pads," or "conductive contacts." A substrate 107 including such layers may be formed using a printed circuit board (PCB) fabrication technique, for example.

An individual layer of dielectric material 112 (e.g., a first dielectric material layer 112A) may include a cavity 119 and the bridge die 114-1 may be at least partially nested in the cavity 119. The bridge die 114-1 may be surrounded by (e.g., embedded in) a next individual layer of dielectric material 112 (e.g., a second dielectric material layer 112B). In some embodiments, a cavity 119 is tapered, narrowing towards a bottom face of the cavity 119 (e.g., the surface towards the first surface 120-1 of the substrate 107). A cavity 119 may be indicated by a seam between the dielectric material 112A and the dielectric material 112B. As shown in FIG. 1, in cases where the bridge die 114-1 is partially nested in a cavity 119, a top face of the bridge die 114-1 may extend above a top face of dielectric material 112A. In cases where the bridge die 114-1 is fully nested in a cavity 119 (not shown), a top face of the bridge die 114-1 may be planar with or below a top face of dielectric material 112A.

A substrate 107 may include N layers of conductive material 108, where N is an integer greater than or equal to one. In FIG. 1, the layers are labeled in descending order from the second surface 120-2 (e.g., the top face) of the substrate 107 (e.g., layer N, layer N-1, layer N-2, etc.). In particular, as shown in FIG. 1, a substrate 107 may include four metal layers (e.g., N, N-1, N-2, and N-3). The N metal layer may include conductive contacts 121 at the second surface 120-2 of the substrate 107 that are coupled to conductive contacts 122 at bottom faces of the die 114-2, 114-3 by DTS interconnects 140. The N-2 metal layer may include conductive traces 108A having a top face (e.g., the surface facing towards the second surface 120-2 of the substrate 107), an opposing bottom face (e.g., the surface facing towards the first surface 120-1 of the substrate 107), and lateral surfaces extending between the top and bottom faces of the conductive traces 108A. A substrate 107 may further include an N-1 metal layer above the N-2 metal layer and below the N metal layer, where a portion of the N-1 metal layer includes a metal ring 118 exposed at a perimeter of the bottom of the cavity 119. The metal ring 118 may be coplanar with the conductive traces 108A of the N-1 metal layer and may be proximate to the edges of the cavity 119, as shown.

Although a particular number and arrangement of layers of dielectric material 112/conductive material 108 are shown in various ones of the accompanying figures, these particular numbers and arrangements are simply illustrative, and any desired number and arrangement of dielectric material 112/conductive material 108 may be used. Further, although a particular number of layers are shown in the substrate 107 (e.g., four layers), these layers may represent only a portion of the substrate 107, for example, further layers may be present (e.g., layers N-4, N-5, N-6, etc.).

As shown in FIG. 1, the substrate 107 may further include a glass core 110 with through-glass vias (TGVs) 115 and further layers 111 may be present below the glass core 110 and coupled to a package substrate 102 by interconnects 150. As used herein, the term "glass core" refers to a layer (e.g., a glass layer) or a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the glass core 110 may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass core 110 may be an amorphous solid glass layer. In some embodiments, the glass core 110 may include a material comprising silicon and oxygen, as well as any one or more of aluminum, boron, magnesium, calcium, barium, tin, sodium, potassium, strontium, phosphorus, zirconium, lithium, titanium, and zinc. In some embodiments, the glass core 110 may include a material, e.g., any of the materials described above, with a weight percentage of silicon being at least about 0.5%, e.g., between about 0.5% and 50%, between about 1% and 48%, or at least about 23%. For example, if the glass core 110 is fused silica, the weight percentage of silicon may be about 47%. In some embodiments, the glass core 110 may include a material having at least 23% silicon and/or at least 26% oxygen by weight, and, in some further embodiments, the glass core 110 may further include at least 5% aluminum by weight. In some embodiments, the glass core 110 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the glass core 110 may be a layer of glass that does not include an organic adhesive or an organic material. The glass core 110 may be distinguished from, for example, the "prepreg" or "RF4" core of a PCB substrate which typically includes glass fibers embedded in a resinous organic material such as an epoxy. In such traditional cores/substrates including glass fibers and epoxy, the diameter of the glass fibers is generally in the range of 5 micron to 200 micron. In contract, the glass core 110 may be a layer of glass that is about 10 millimeters on a side to about 250 millimeters on a side (e.g., 10 millimeters x 10 millimeters to 250 millimeters x 250 millimeters). In some embodiments, a cross-section of the glass core 110 in an x-z plane, a y-z plane, and/or an x-y plane of an example coordinate system 105, shown in FIG. 1, may be substantially rectangular (axes shown in subsequent drawings refer to the axes of the coordinate system 105). In such embodiments, in the top-down view of the glass core 110 (e.g., the x-y plane of the coordinate system 105), the glass core 110 may have a first length in a range of 10 millimeters to 250 millimeters, and a second length in a range of 10 millimeters to 250 millimeters, the first length perpendicular to the second length. A thickness of the glass core 110 (e.g., a dimension measured along the z-axis of the coordinate system 105) may be in a range of about 50 micron to 1.4 millimeters. In some embodiments, the glass core 110 may be a glass core substrate, where the glass core substrate has a thickness in a range of about 50 microns to 1.4 millimeters. In some embodiments, the glass core 110 may be a layer of glass comprising a rectangular prism volume. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass core 110 may be a rectangular prism volume with sections (e.g., vias) removed and filled with other materials (e.g., metal) e.g., the TGVs 115. In some embodiments, the glass core 110 may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length.

In some implementations, together, the substrate 107, including the glass core 110, and the dies 114 may be referred to as a "a multi-layer die subassembly 104." The glass core 110 may provide mechanical stability to the multi-layer die subassembly 104, the substrate 107, and/or the microelectronic assembly 100. The glass core 110 may reduce warpage and may provide a more robust surface for attachment of the multi-layer die subassembly 104 to a package substrate 102 or other substrate (e.g., an interposer or a circuit board).

In some implementations, together, the dielectric material 112 of the substrate 107 and the glass core 110 may be referred to as a "multi-layer glass substrate." In some such embodiments, the multi-layer glass substrate may be a coreless substrate. In some such embodiments, the glass core 110 may be a glass layer having a thickness in a range of about 25 microns to 50 microns. In some embodiments, the further layers 111 may also be part of the multi-layer glass substrate.

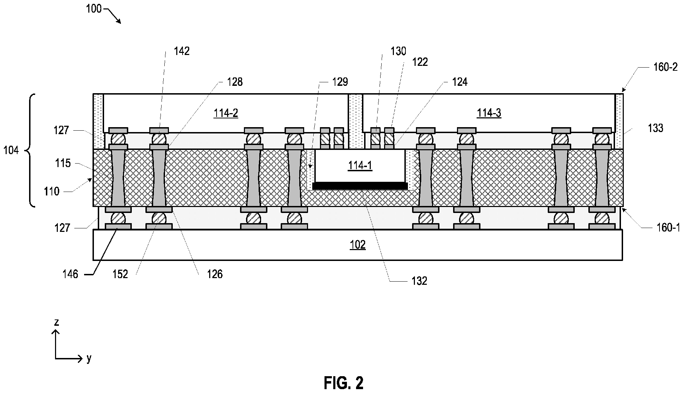

The TGVs 115 may be vias extending between a first side and a second side of the glass core 110 (e.g., between the bottom face and the top face of the glass core 110), the vias including any appropriate conductive material, e.g., a metal such as copper, silver, nickel, gold, aluminum, or other metals or alloys, for example. The TGVs 115 may be formed using any suitable process, including, for example, a direct laser drilling or laser induced deep etching process. In some embodiments, the TGVs 115 disclosed herein may have a pitch between 50 microns and 500 microns, e.g., as measured from a center of one TGV 115 to a center of an adjacent TGV 115. The TGVs 115 may have any suitable size and shape. In some embodiments, the TGVs 115 may have a circular, rectangular, or other shaped cross-section. In some embodiments, at least some of the TGVs 115 may have an hourglass shape, e.g., as shown in FIG. 2. In some embodiments, at least some of the TGVs 115 may taper down from one face of the glass core 110 to another, e.g., from the top face of the glass core 110 to the bottom face of the glass core 110.

The substrate 107 (e.g., further layers 111) may be coupled to a package substrate 102 by STPS interconnects 150. In particular, the top face of the package substrate 102 may include a set of conductive contacts 146. Conductive contacts 144 on the bottom face of the substrate 107 may be electrically and mechanically coupled to the conductive contacts 146 on the top face of the package substrate 102 by the STPS interconnects 150. The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire retardant grade 4 material (FR-4), bismaleimide triazine (BT) resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 102 is formed using standard PCB processes, the package substrate 102 may include FR-4, and the conductive pathways in the package substrate 102 may be formed by patterned sheets of copper separated by build-up layers of the FR-4. The conductive pathways in the package substrate 102 may be bordered by liner materials, such as adhesion liners and/or barrier liners, as suitable. In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material, and creating conductive vias and lines by laser drilling and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the die 114 may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual-damascene process. In some embodiments, additional dies may be disposed on the top face of the dies 114-2, 114-3. In some embodiments, additional components may be disposed on the top face of the dies 114-2, 114-3. Additional passive components, such as surface-mount resistors, capacitors, and/or inductors, may be disposed on the top face or the bottom face of the package substrate 102, or embedded in the package substrate 102.

The microelectronic assembly 100 of FIG. 1 may also include an underfill material 127. In some embodiments, the underfill material 127 may extend between the substrate 107 and the package substrate 102 around the associated STPS interconnects 150. In some embodiments, the underfill material 127 may extend between different ones of the top level dies 114-2, 114-3 and the top face of the substrate 107 around the associated DTS interconnects 140 and between the bridge die 114-1 and the top level dies 114-2, 114-3 around the DTD interconnects 130. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering the multi-layer die subassembly 104 to the package substrate 102 when forming the STPS interconnects 150, and then polymerizes and encapsulates the STPS interconnects 150. The underfill material 127 may be selected to have a CTE that may mitigate or minimize the stress between the substrate 107 and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the dies 114 and/or dielectric material 112 of the substrate 107.

The STPS interconnects 150 disclosed herein may take any suitable form. In some embodiments, a set of STPS interconnects 150 may include solder (e.g., solder bumps or balls that are subject to a thermal reflow to form the STPS interconnects 150), for example, as shown in FIG. 1, the STPS interconnects 150 may include solder between a conductive contacts 144 on a bottom face of the substrate 107 and a conductive contact 146 on a top face of the package substrate 102. In some embodiments, a set of STPS interconnects 150 may include an anisotropic conductive material, such as an anisotropic conductive film or an anisotropic conductive paste. An anisotropic conductive material may include conductive materials dispersed in a non-conductive material.

The DTD interconnects 130 disclosed herein may take any suitable form. The DTD interconnects 130 may have a finer pitch than the STPS interconnects 150 in a microelectronic assembly. In some embodiments, the dies 114 on either side of a set of DTD interconnects 130 may be unpackaged dies, and/or the DTD interconnects 130 may include small conductive bumps (e.g., copper bumps). The DTD interconnects 130 may have too fine a pitch to couple to the package substrate 102 directly (e.g., too fine to serve as DTS interconnects 140 or STPS interconnects 150). In some embodiments, a set of DTD interconnects 130 may include solder. In some embodiments, a set of DTD interconnects 130 may include an anisotropic conductive material, such as any of the materials discussed above. In some embodiments, the DTD interconnects 130 may be used as data transfer lanes, while the STPS interconnects 150 may be used for power and ground lines, among others. In some embodiments, some or all of the DTD interconnects 130 in a microelectronic assembly 100 may be metal-to-metal interconnects (e.g., copper-to-copper interconnects, or plated interconnects). In such embodiments, the DTD interconnect 130 may be bonded together (e.g., under elevated pressure and/or temperature) without the use of intervening solder or an anisotropic conductive material. Any of the conductive contacts disclosed herein (e.g., the conductive contacts 122, 124, 144, and/or 146) may include bond pads, solder bumps, conductive posts, or any other suitable conductive contact, for example. In some embodiments, some or all of the DTD interconnects 130 and/or the DTS interconnects 140 in a microelectronic assembly 100 may be solder interconnects that include a solder with a higher melting point than a solder included in some or all of the STPS interconnects 150. For example, when the DTD interconnects 130 and the DTS interconnects 140 in a microelectronic assembly 100 are formed before the STPS interconnects 150 are formed, solder-based DTD interconnects 130 and DTS interconnects 140 may use a higher-temperature solder (e.g., with a melting point above 200 degrees Celsius), while the STPS interconnects 150 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

In the microelectronic assemblies 100 disclosed herein, some or all of the DTS interconnects 140 and the STPS interconnects 150 may have a larger pitch than some or all of the DTD interconnects 130. DTD interconnects 130 may have a smaller pitch than STPS interconnects 150 due to the greater similarity of materials in the different dies 114 on either side of a set of DTD interconnects 130 than between the substrate 107 and the top level dies 114-2, 114-3 on either side of a set of DTS interconnects 140, and between the substrate 107 and the package substrate 102 on either side of a set of STPS interconnects 150. In particular, the differences in the material composition of a substrate 107 and a die 114 or a package substrate 102 may result in differential expansion and contraction due to heat generated during operation (as well as the heat applied during various manufacturing operations). To mitigate damage caused by this differential expansion and contraction (e.g., cracking, solder bridging, etc.), the DTS interconnects 140 and the STPS interconnects 150 may be formed larger and farther apart than DTD interconnects 130, which may experience less thermal stress due to the greater material similarity of the pair of dies 114 on either side of the DTD interconnects. In some embodiments, the DTS interconnects 140 disclosed herein may have a pitch between 25 microns and 250 microns. In some embodiments, the STPS interconnects 150 disclosed herein may have a pitch between 55 microns and 1000 microns, while the DTD interconnects 130 disclosed herein may have a pitch between 25 microns and 100 microns.

The microelectronic assembly 100 of FIG. 1 may also include a circuit board (not shown). The package substrate 102 may be coupled to the circuit board by second-level interconnects at the bottom face of the package substrate 102. The second-level interconnects may be any suitable second-level interconnects, including solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the second-level interconnects may not couple the package substrate 102 to a circuit board, but may instead couple the package substrate 102 to another IC package, an interposer, or any other suitable component. In some embodiments, the substrate 107 may not be coupled to a package substrate 102, but may instead be coupled to a circuit board, such as a PCB.

Although FIG. 1 depicts a microelectronic assembly 100 having a substrate with a particular number of dies 114 and conductive pathways provided by the conductive material 108 coupled to other dies 114, this number and arrangement are simply illustrative, and a microelectronic assembly 100 may include any desired number and arrangement of dies 114. Although FIG. 1 shows the die 114-1 as a double-sided die and the dies 114-2, 114-3 as single-sided dies, the dies 114-2, 114-3 may be double-sided dies and the dies 114 may be a single-pitch die or a mixed-pitch die. In some embodiments, additional components may be disposed on the top face of the dies 114-2 and/or 114-3. In this context, a double-sided die refers to a die that has connections on both surfaces. In some embodiments, a double-sided die may include through TSVs to form connections on both surfaces. The active surface of a double-sided die, which is the surface containing one or more active devices and a majority of interconnects, may face either direction depending on the design and electrical requirements.

Many of the elements of the microelectronic assembly 100 of FIG. 1 are included in other ones of the accompanying drawings; the discussion of these elements is not repeated when discussing these drawings, and any of these elements may take any of the forms disclosed herein. Further, various elements are illustrated in FIG. 1 as included in the microelectronic assembly 100, but, in various embodiments, some of these elements may not be included. For example, in various embodiments, the further layers 111, the underfill material 127, and the package substrate 102 may not be present in the microelectronic assembly 100. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

FIG. 2 is a schematic cross-sectional view of another example microelectronic assembly 100 according to some embodiments of the present disclosure. The configuration of the embodiment shown in the figure is like that of FIG. 1, except for differences as described further. Instead of including the glass core 110 as a part of the substrate 107, as was shown in FIG. 1, the microelectronic assembly 100 of FIG. 2 includes a glass core 110 on its own, where one or more dies 114 may be coupled to the glass core 110. In FIG. 2, the multi-layer die subassembly 104 includes the glass core 110 and the plurality of dies 114 as described above. The multi-layer die subassembly 104 may have a first surface 160-1 (e.g., the bottom face) and an opposing second surface 160-2 (e.g., the top face). The glass core 110 may provide mechanical stability to the multi-layer die subassembly 104 and/or the microelectronic assembly 100 of FIG. 2, may reduce warpage, and may provide a more robust surface for attachment of the multi-layer die subassembly 104 to a package substrate 102 or other substrate (e.g., an interposer or a circuit board).

The glass core 110 may include a cavity 129 with an opening facing the second surface 160-2 and the die 114-1 may be nested, fully or at least partially, in the cavity 129. As shown in FIG. 2, in cases where the die 114-1 is fully nested in a cavity 129, a top face of the die 114-1 may be planar with or below a top face of the glass core 110. In cases where the die 114-1 is partially nested in a cavity 129, a top face of the die 114-1 may extend above a top face of the glass core 110. The cavity 129 may be at least partially filled with a dielectric material 112A or 112B, described above. The die 114-1 may be attached to a bottom face of the cavity 129 by a die-attach film (DAF) 132. A DAF 132 may be any suitable material, including a non-conductive adhesive, die-attach film, a B-stage underfill, or a polymer film with adhesive property. A DAF 132 may have any suitable dimensions, for example, in some embodiments, a DAF 132 may have a thickness (e.g., height or z-height) between 5 microns and 10 microns.

The die 114-1 may be coupled to the dies 114-2, 114-3 in a layer above the die 114-1 through the DTD interconnects 130. The DTD interconnects 130 may be disposed between some of the conductive contacts 122 at the bottom of the dies 114-2, 114-3 and some of the conductive contacts 124 at the top of the die 114-1. Some other conductive contacts 122 at the bottom of the dies 114-2 and/or 114-3 may further couple one or more of the dies 114-2, 114-3 to the glass core 110 by glass core-to-die (GCTD) interconnects 142. The GCTD interconnects 142 may be disposed between some of the conductive contacts 122 at the bottom of the dies 114-2, 114-3 and some of the conductive contacts 128 at the top of the glass core 110. The GCTD interconnects 142 may be similar to the DTS interconnects 140, described above. In some embodiments, the underfill material 127 may extend between different ones of the dies 114 around the associated DTD interconnects 130 and/or GCTD interconnects 142. In some embodiments, a die 114-2 and/or a die 114-3 may be embedded in an insulating material 133. In some embodiments, an overall thickness (e.g., a z-height) of the insulating material 133 may be between 200 microns and 800 microns (e.g., substantially equal to a thickness of die 114-2 or 114-3 and the underfill material 127). In some embodiments, the insulating material 133 may form multiple layers (e.g., a dielectric material formed in multiple layers, as known in the art) and may embed one or more dies 114 in a layer. In some embodiments, the insulating material 133 may be a dielectric material, such as an organic dielectric material, a fire retardant grade 4 material (FR-4), BT resin, polyimide materials, glass reinforced epoxy matrix materials, or low-k and ultra low-k dielectric (e.g., carbon-doped dielectrics, fluorine-doped dielectrics, porous dielectrics, and organic polymeric dielectrics). In some embodiments, the insulating material 133 may be a mold material, such as an organic polymer with inorganic silica particles.

As shown in FIG. 2, the glass core 110 may further include conductive contacts 126 at the bottom of the glass core 110, and TGVs 115 may extend between and electrically couple conductive contacts 126 at the bottom of the glass core 110 and conductive contacts 128 at the top of the glass core 110. The conductive contacts 126, 128 may be similar to other conductive contacts disclosed herein (e.g., the conductive contacts 122, 124, 144, and/or 146), and may include bond pads, solder bumps, conductive posts, or any other suitable conductive contact, for example. As shown in FIG. 2, in some embodiments, at least some of the TGVs 115 may have an hourglass shape. For example, at least some of the TGVs 115 may has a first width at the first face of the glass core 110 (e.g., at the bottom face of the glass core 110), a second width at the second face of the glass core 110 (e.g., at the top face of the glass core 110), and a third width between the first face and the second face of the glass core 110, where the third width is smaller than the first width and the second width.

The dies 114-2, 114-3 may be electrically coupled to the package substrate 102 through the TGVs 115 and glass core-to-package substrate (GCTPS) interconnects 152, which may be power delivery interconnects or high-speed signal interconnects. The GCTPS interconnects 152 may be similar to the STPS interconnects 150, described above. The top face of the package substrate 102 may include a set of conductive contacts 146, the multi-layer die subassembly 104 may include a set of conductive contacts 126 on the first surface 160-1, and the GCTPS interconnects 152 may be between, and couple the conductive contacts 146 with corresponding ones of the conductive contacts 126. In some embodiments, the underfill material 127 may extend between the glass core 110 and the package substrate 102 around the associated GCTPS interconnects 152.

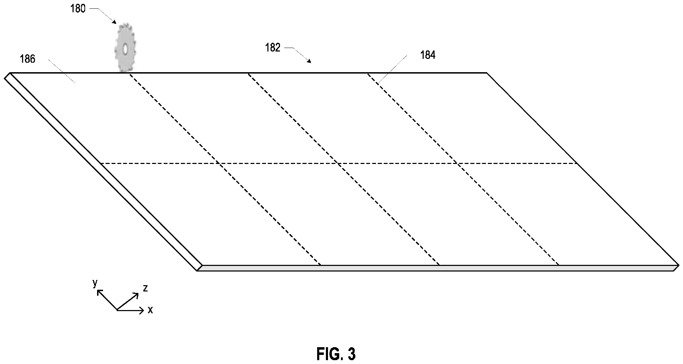

The glass core 110 included in a microelectronic assembly 100 as described with reference to FIG. 1 or FIG. 2 or included in any other microelectronic assembly or device, may be subject to edge stress and, therefore, susceptible to crack formation and propagation. For example, FIG. 3 illustrates singulation of a glass panel that may cause edge stress in glass cores. As shown in FIG. 3, during singulation process, a cutting tool 180 (e.g., a glass cutter, a diamond blade, or a saw) may be used to cut a glass panel 182 along some or all of saw streets 184 to separate the glass panel 182 into individual glass units 186 or into smaller blocks of two or more glass units 186. The saw streets 184 are referred to herein as "saw streets" although they may also be referred to as "scribe lines," "saw lines," or "singulation lines/streets."

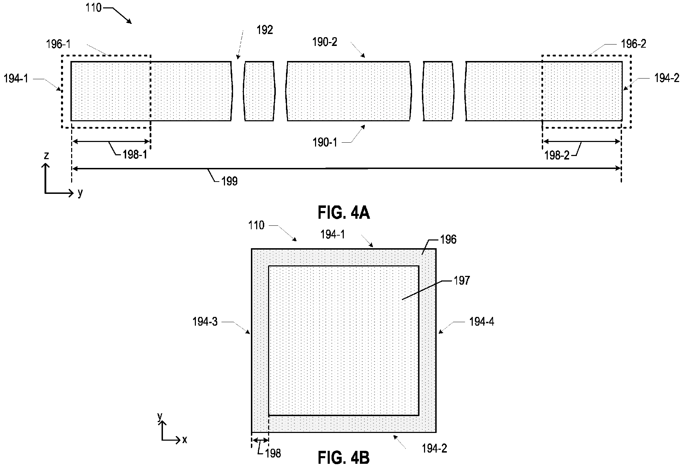

After singulation, any of the glass units 186 may serve as a glass core 110. However, as a result of cutting, the surfaces of the glass units 186 along the saw streets 184 (i.e., at least some edges of the glass units 186) may be subject to edge stress and, as a result, may have cracks or fractures, have high surface roughness or jagged edges, or may be otherwise uneven. One or more edge features as described herein may be implemented in the glass panel 182 before the singulation process so that, after singulation, crack formation and/or propagation in a glass core 110 formed by one of the singulated glass unit 186 may be reduced. FIGS. 4A-4B illustrate approximate locations of edge features in a glass core 110, according to some embodiments of the present disclosure. In particular, FIG. 4A illustrates a cross-sectional side view of a glass core 110, while FIG. 4B illustrates a top-down view of a glass core 110 (not to scale with the glass core 110 shown in FIG. 4A). As shown in FIG. 4A, a glass core 110 may include a first face 190-1 and an opposing second face 190-2, which may, e.g., be bottom and top surfaces of the glass core 110 when the glass core 110 is included in a microelectronic assembly 100. When TGVs are formed in the glass core 110, e.g., the TGVs 115 described above, openings 192 may first be formed in the glass core 110, extending between the first face 190-1 and the second face 190-2, where the openings 192 may then be filled with one or more conductive materials, such as copper. FIG. 4A also illustrates opposite edges 194-1 and 194-2, and FIG. 4B further illustrates the other pair of opposite edges 194-3 and 194-4 (the four edges 194-1, 194-2, 194-3, and 194-4 collectively referred to herein as "edges 194"), where the edges 194 are surfaces of the glass core 110 that extend between the first face 190-1 and the second face 190-2. FIG. 4A further illustrates edge regions 196-1 and 196-2 (collectively referred to herein as "edge regions 196"), where one or more edge features as described herein may be implemented. As shown in FIG. 4A, the edge region 196-1 is a region including the edge 194-1 and extending from the edge 194-1 into the glass core 110 (i.e., extending towards the opposite edge 194-2) by a certain depth 198-1, while the edge region 196-2 is a region including the edge 194-2 and extending from the edge 194-2 into the glass core 110 (i.e., extending towards the opposite edge 194-1) by a certain depth 198-2. In various embodiments, the depths 198-1, 198-2 may be less than about 10% (e.g., less than about 7% or less than about 5%) of the total width 199 (e.g., a dimension of the glass core 110 measured in the same direction as the depths 198-1, 198-2) of the glass core 110. FIG. 4B illustrates that a single edge region 196 may be defined as a closed contour that follows each of the edges 194 of the glass core 110 and extends from the edges 194 of the glass core 110 by a certain depth 198 (the depth 198 measured in a direction perpendicular to the respective edges 194). Such a single edge region 196 may be similar to a ring around an active area 197 of the glass core 110, except that the footprint (e.g., top-down) shape of it is not circular as in a ring, but rectangular. The active area 197 may be an area where TGVs 115 are implemented, and/or an area within which other components are coupled to the glass core 110. In general, the edge region 196 only occupies a portion of the total area of a face 190 of the glass core 110, e.g., less than about 20% (e.g., less than about 10% or less than about 5%) of the total area of a face 190 of the glass core 110. FIG. 4B illustrates the edge region 196 that has four portions along the four edges 194, where all portions have the same depth 198, but this may be different in other embodiments in that the edge region 196 along different edges 194 may have different depths 198.

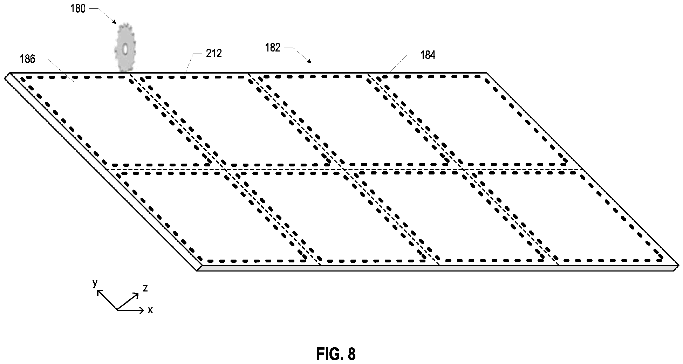

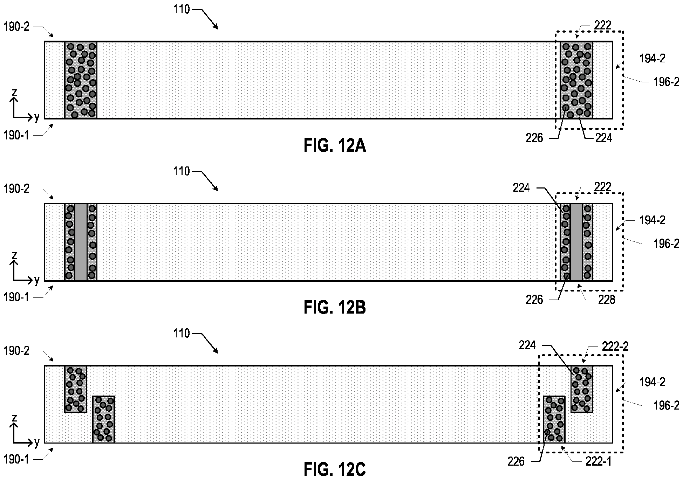

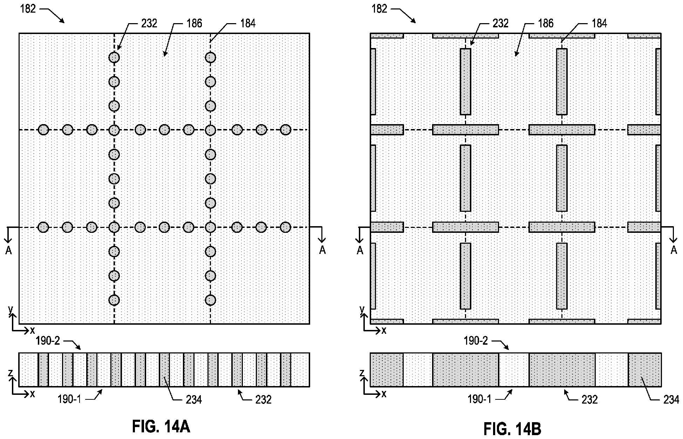

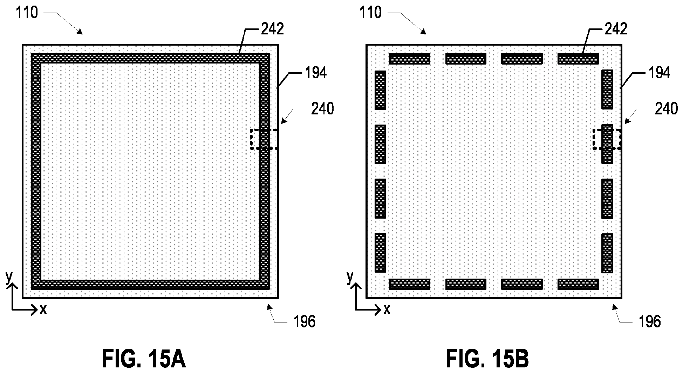

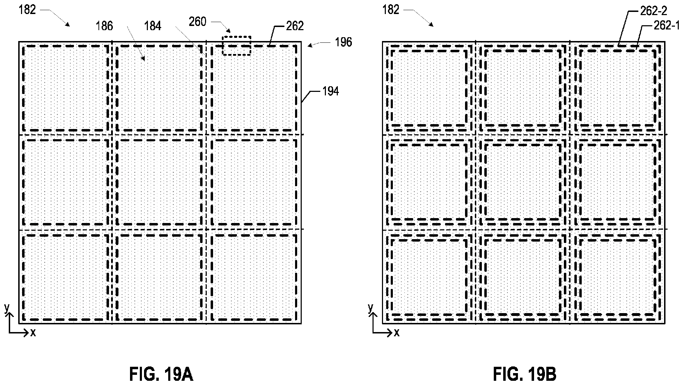

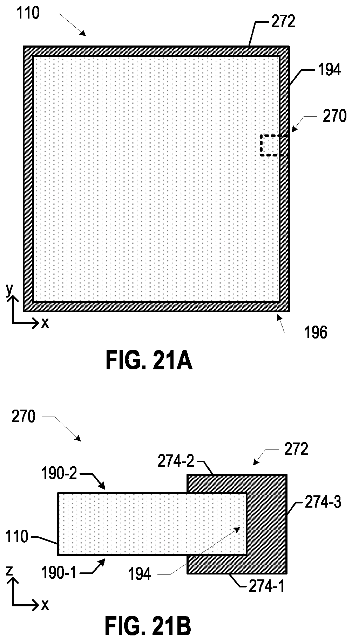

One or more edge features as described herein may be implemented in any one or more of the edge regions 196. At a high level, edge features described herein may be categorized as edge features based on reducing crack propagation in glass cores 110 (e.g., edge features illustrated in FIGS. 5-13), edge features based on reducing crack formation in glass cores 110 (e.g., edge features illustrated in FIG. 14), and edge features based on reducing edge stress in glass cores 110 (e.g., edge features illustrated in FIGS. 15-22). Edge features based on reducing crack propagation in glass cores 110 may further be categorized as edge features based on setting a crack propagation barrier (e.g., edge features illustrated in FIGS. 5-11) and edge features based on fixing cracks (e.g., edge features illustrated in FIG. 12). Edge features based on setting a crack propagation barrier may be categorized even further as continuous edge features along the edges (e.g., edge features illustrated in FIGS. 5-7) and discontinuous edge features along the edges (e.g., edge features illustrated in FIGS. 8-11). Edge features based on reducing edge stress in glass cores 110 may further be categorized as anchors (e.g., edge features illustrated in FIGS. 15-18), daisy chain features (e.g., edge features illustrated in FIGS. 19-20), and edge clamp features (e.g., edge features illustrated in FIGS. 21-22). In some embodiments, each of the edge features described herein may be implemented in a glass core 110 as a stand-alone edge feature to help mitigate or reduce crack formation and/or propagation. In other embodiments, two or more different edge features described herein, in any combination, may be implemented for a glass core 110. Details of various techniques will now be described. It should be noted that, although some drawings illustrating various embodiments of edge features show glass cores 110 (e.g., FIGS. 5A-5D), it is to be understood that the same features may be applied to a glass panel 182 or a structure that is smaller than a glass panel 182 but larger than a glass core 110, e.g., to a structure that includes a plurality of the individual glass units 186 (e.g., half of the glass panel 182 or quarter of the glass panel 182). Although FIGS. 5-22 do not show TGVs 115 in any of the glass cores 110 and do not show other components that may be coupled to the glass cores 110, this is only in order to not clutter the drawings, and, in general, the glass cores 110 shown in any of FIGS. 5-22 may be the glass cores 110 as described with reference to, e.g., FIG. 1 or FIG. 2.

FIGS. 5A-5D provide cross-sectional side views of glass cores 110 illustrating a process of including edge features in the form of continuous trenches as part of preparing for singulation, according to some embodiments of the present disclosure. In FIGS. 5A-5D, as well as in other drawings showing similar illustrations (e.g., FIGS. 7A-7D or FIGS. 12A-12C), only the edge 194-2 and the edge region 196-2 are labeled and discussed, and the edge 194-1 and the region 196-1 are not labeled to not clutter the drawings, but the same considerations are applicable to the edge 194-1 and the region 196-1 as the ones provided here.

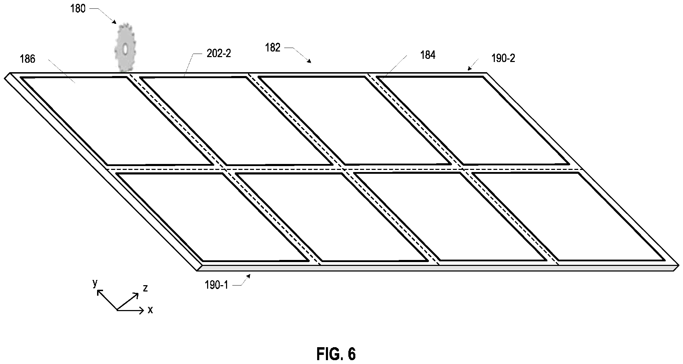

FIG. 5A illustrates that the process may begin with forming trenches 202-1 in the first face 190-1 and forming trenches 202-2 in the second face 190-2 of a glass core 110. In various embodiments, processes such as dry etching, wet etching, or laser modification followed by wet etching may be used to form the trenches 202-1 and 202-2 (collectively referred to as "trenches 202"). As shown in FIG. 5A, the trenches 202 are provided in the edge region 196-2, adjacent to the edge 194-2. In some embodiments, the distance between the closest one of the trenches 202-1 and 202-2 to the nearest edge 194 (e.g., to the edge 194-2 for the edge region 196-2) may be less than about 3% of the total width 199 of the glass core 110, e.g., less than about 1% or less than about 0.5%. The trenches 202-1 and 202-2 may be offset with respect to one another, meaning that, for a given edge region 196, the distance from the trench 202-1 to the nearest edge 194 may be different than the distance from the trench 202-2 to the nearest edge 194. FIG. 6 illustrates a glass panel 182 with the trenches 202-2 as shown in FIG. 5A, provided in the second face 190-2 (the trenches 202-1 are not seen in the view of FIG. 6 because they are at the bottom of the glass panel 182 shown in this drawing). FIG. 6 shows that the trenches 202 may be continuous trenches, located just inset of the saw streets 194. In some embodiments, the depth of the trenches 202 (i.e., a dimension measured along the z-axis of the coordinate system 105) may be slightly greater than about half of the thickness of the glass core 110, e.g., between about 51% and 99% of the thickness of the glass core 110 or between about 51% and 60% of the thickness of the glass core 110. Implementing the trenches 202-1 and 202-2 being offset from one another and each extending to a depth greater than about half of the thickness of the glass core 110 may help ensure that, if cracks are formed at the edge 194-2, they cannot propagate into the glass core 110 further than the edge region 196-2 because the trenches 202-1 and 202-2 will be in their propagation path and will obstruct propagation of the cracks. In other embodiments, the depth of the trenches 202 may be equal or less than half of the thickness of the glass core 110, e.g., between about 25% and 50% of the thickness of the glass core 110 or between about 35% and 50% of the thickness of the glass core 110. Such embodiments may be less effective in reducing crack propagation but be advantageous in terms of simpler fabrication because the trenches 202 are shallower.

In some embodiments, the trenches 202 may be filled with a fill material 204, and an overburden of the fill material 204 (i.e., portions deposited on the first and second faces 190-1, 190-2) may be removed, e.g., using any suitable planarization process such as chemical-mechanical polishing (CMP). A result of this is shown in FIG. 5B. The fill material 204 may include any material that may be deposited easily in to the trenches 202 (e.g., using lamination, molding, or liquid coating such as spin-coating, dip-coating, or spray-coating, or other deposition techniques). In some embodiments, the fill material 204 may include ABF, a mold material, a polymer material, or an organic or inorganic insulator material. In some embodiments, the fill material 204 may be a material having a relatively low Young's modulus, e.g., between about 1 gigapascal (GPa) and 10 GPa, where the Young's modulus may be defined as the ratio of stress to strain in a material undergoing deformation. Such embodiments may help dissipate stress better. In some embodiments, the fill material 204 may be a material having a relatively low Poisson's ratio, e.g., less than about 0.25, where the Poisson's ratio may be defined as the negative ratio of transverse strain to axial strain. Such embodiments may also help dissipate stress better.

In some embodiments, the fill material 204 may be a material having a relatively low CTE. CTE is a measure of how a material expands or contracts with changes in temperature and is typically defined as the fractional increase in length per unit rise in temperature, measured in, e.g., parts per million (ppm) per degrees Kelvin (K) or ppm/K. Materials that may be used for glass cores and metals (e.g., metals filling TGVs in glass cores) have significantly different CTEs. Metals have relatively high CTEs, meaning that they may expand and contract significantly with changes in temperature. Glass, on the other hand, has a much lower CTE and is less responsive to temperature changes. For example, a CTE of glass may be on the order of about 3.5 ppm/K, while a CTE of a metal such as copper may be on the order of about 15 ppm/K. When a metal is in close contact with glass (e.g., a metal within a TGV in the glass core), and the assembly is exposed to temperature variations such as heating or cooling, the metal will heat up or cool down much faster, and to a greater extent, than the glass. This leads to the generation of significant thermal stress at the interface between the two materials. The high thermal stress can exceed the strength of the glass, leading to the formation of cracks, which may then propagate and compromise the structural integrity of the glass. Even if cracks don't form immediately, the repeated thermal cycling can gradually weaken the glass surface, potentially leading to the development of surface flaws or micro-cracks. Prolonged exposure to CTE mismatch-induced stresses can cause gradual degradation of the glass, making it more prone to failure over time. Including the fill material 204 as a material having a CTE lower than that of metals using in other portions of the glass core 110 (e.g., in the TGVs 115, not specifically shown in FIG. 5 and other drawings illustrating various edge features) may help reduce issues associated with the CTE mismatch-induced stresses. In some embodiments, the fill material 204 may be a material having a CTE below about 15 ppm/K, e.g., below about 10 ppm/K or below about 7 ppm/K.

In some embodiments, the trenches 202 may be fully filled with the fill material 204. In other embodiments, the trenches 202 may be partially filled with the fill material 204 (e.g., only on sidewalls), and have gaps in the center, where the gaps may be left substantially empty (i.e., as voids) or may be filled with some other materials that are not metals. In some embodiments, the fill material 204 may be in at least 50% or in at least 75% of the volume of a trench 202. In some embodiments, the trenches 202 may not include any metals.

FIG. 5C illustrates that, in some embodiments, build-up layers 206 may be provided on the first face 190-1, on the second face 190-2, or on both faces 190, after the trenches 202 have been formed and filled with the fill material 204. The build-up layers 206 may take the embodiments of layers of the dielectric material 112, further layers 111 below the glass core 110, and may be implemented as part of the substrate 107 above and below the glass core 110, as described with reference to FIG. 1. In some embodiments utilizing the build-up layers 206, the overburden of the fill material 204 does not have to be removed as was shown in FIG. 5B because the fill material 204 deposited on the faces 190 may be the first layer of the build-up layers 206.

FIG. 5D illustrates the cutting tool 180, as described above, starting to cut the glass core 110 (or, rather, the glass panel 182 that includes the glass core 110) along a saw street 184. In FIG. 5D, horizontal arrows extending away from the saw street 184 and into the glass core 110 illustrate example directions of propagation of cracks that may be formed at the cutting edge during the cutting process. As shown in FIG. 5D, the trenches 202-1 and 202-2 obstruct the path of crack propagation, thus helping to reduce crack propagation in the glass core 110.

Other variations to the idea of including edge features in the form of continuous trenches as shown in FIGS. 5A-5D are possible, all being within the scope of the present disclosure. For example, while FIGS. 5A-5D illustrate the trenches 202 on both faces 190 of the glass core 110, in some embodiments, either the trenches 202-1 or the trenches 202-2 may be absent. Such embodiments may obstruct propagation of cracks to a lesser extent than having the trenches 202 on both faces 190 but may have the advantage of simplified manufacturing because trenches 202 only need to be provided on one of the faces 190. In such embodiments, the trenches 202 may extend deeper into the glass core 110, e.g., to a depth that is about 60-80% of the thickness of the glass core 110. In another example, the trenches 202-1 and 202-2 may extend to a depth that is less than half of the thickness of the glass core 110, e.g., as shown in FIG. 7A, which is otherwise the same as FIG. 5B described above. Such embodiments may obstruct propagation of cracks to a lesser extent than having the trenches 202 extend to a depth greater than about half of the thickness of the glass core 110 but may have the advantage of simplified manufacturing because trenches 202 are shallower. In yet another example, the trenches 202 do not have to be filled with the fill material 204 and may be left as voids. Furthermore, FIGS. 5A-5D illustrate the trenches 202 to have a rounded shape in their cross-sectional profile because such shapes are expected to perform better than rectangular shapes or other shapes with sharp corners due to stress concentration factors. However, in other embodiments, the cross-sectional profiles of the trenches 202 may be different. For example, FIGS. 7B-7C illustrate glass cores 110 the same as shown in FIG. 5B but with the trenches 202 having cross-sectional profiles that are square (FIG. 7B), trapezoidal (FIG. 7C) and triangular (FIG. 7D).

Instead of the edge features being continuous trenches near the edges 194 of glass cores 110, in some embodiments, edge features may be provided in the form of discontinuous openings just inset from the saw streets 184, as is shown in FIG. 8 with discontinuous openings 212 illustrated as vias. In some embodiments, the discontinuous openings 212 may be at least partially filled with the fill material 204 but in other embodiments the discontinuous openings 212 may be left empty (e.g., be left as openings or voids, similar to the embodiment described above for the trenches 202). Further considerations regarding the amount of the fill material 204 in the trenches 202, provided above, are applicable to filling the discontinuous openings 212 with the fill material 204 and, for the sake of brevity, are not repeated.

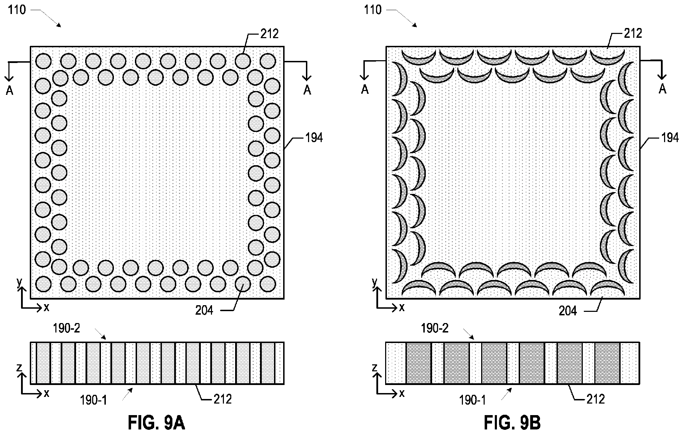

In some embodiments, the discontinuous openings 212 may follow the contour of the trenches 202-2 described above and may be blind openings (e.g., blind vias), e.g., the discontinuous openings 212 may extend from the second face 190-2 towards the first face 190-1 but not reach the first face 190-1. In some such embodiments, additional discontinuous openings 212 may also be provided on the other face 190 of the glass core 110, e.g., following the contour of the trenches 202-1 described above. For example, such additional discontinuous openings 212 may extend from the first face 190-1 towards the second face 190-2 but not reach the second face 190-2. In other embodiments, the discontinuous openings 212 may be through-glass openings (e.g., TGVs) and may extend all the way through the thickness of the glass core 110, i.e., extend between the first face 190-1 and the second face 190-2, e.g., as shown in the cross-sectional side view (x-z plane) of FIG. 9A. The cross-sectional side views shown in FIGS. 9A-9B are cross-sections along the planes AA shown in the top-down views of FIGS. 9A-9B. In some embodiments where the discontinuous openings 212 are through-glass openings, they may be at least partially filled with a metal such as copper, which may help hold the glass core 110 together and prevent it from splitting/delaminating.

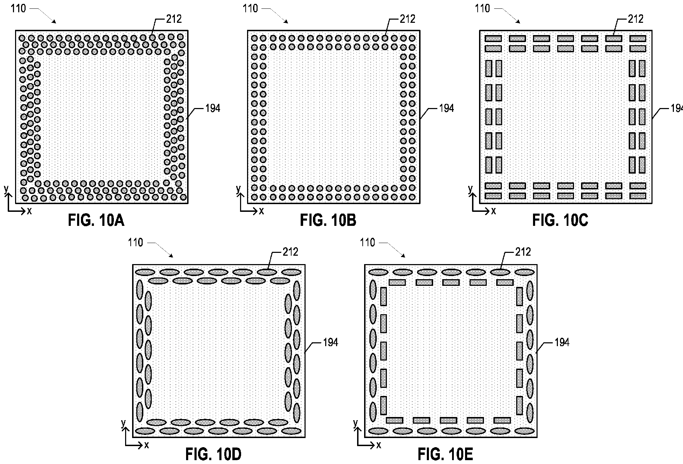

In some embodiments, the discontinuous openings 212 may be provided in multiple rows along a given edge 194, and the multiple rows may be offset with respect to one another, as is shown in the top-down view of FIG. 9A with two rows of discontinuous openings 212 along a given edge 194. For example, the rows may be along the contours of the trenches 202-1 and 202-2, described above, but the trenches 212 may be replaced with discontinuous openings 212, e.g., discontinuous openings 212 implemented as TGVs (as shown in the cross-sectional side view of FIG. 9A). Having individual rows of discontinuous openings 212 being offset with respect to one another may be particularly advantageous in terms of obscuring the path of crack propagation starting from the edges 194 and going into the glass core 110. In other embodiments, the discontinuous openings 212 may be provided in multiple rows but not offset with respect to one another, as is shown in FIG. 10B. In still other embodiments, the discontinuous openings 212 may be provided in more than two rows along a given edge 194, e.g., as is shown in FIG. 10A with three rows of discontinuous openings 212 along a given edge 194.

While FIG. 8, FIG. 9A, FIG. 10A, and FIG. 10B illustrate the discontinuous openings 212 as vias, in other embodiments, the discontinuous openings 212 may have other shapes. For example, FIG. 9B illustrates an example of the discontinuous openings 212 being sickle shaped in their top-down views, FIG. 10C illustrates an example of the discontinuous openings 212 being rectangular in their top-down views, and FIG. 10D illustrates an example of the discontinuous openings 212 being oval in their top-down views. Furthermore, in some embodiments where the discontinuous openings 212 are provided in multiple rows along a given edge 194, the shapes of the discontinuous openings 212 may be different in different rows, as shown in FIG. 10E.

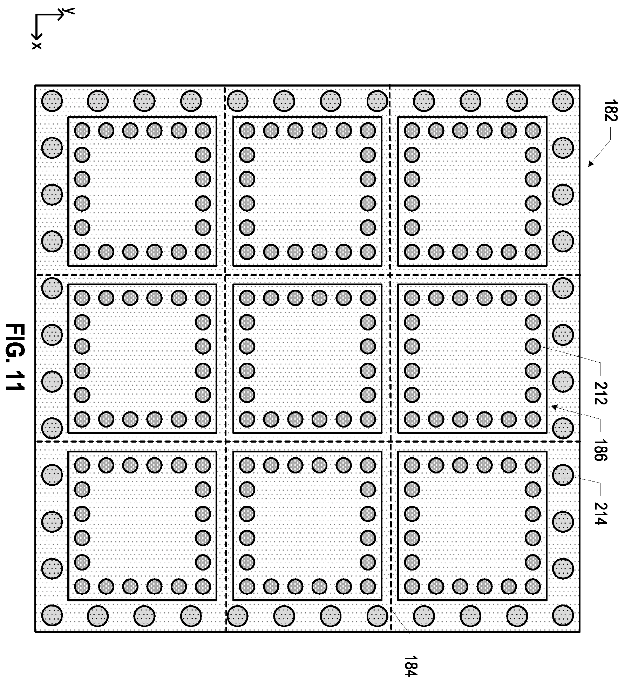

While FIGS. 8-10 illustrate the discontinuous openings 212 in individual glass cores 110, in some embodiments, similar discontinuous openings may be provided near the edges of a glass panel 182. An example of this is illustrated in FIG. 11, showing a glass panel 182 with edge features in the form of discontinuous openings 212 in the edge regions of glass units 186 (which later become the glass cores 110), as well as discontinuous openings 214 in the edge regions of the glass panel 182, according to some embodiments of the present disclosure. All of the descriptions provided with respect to the discontinuous openings 212 are applicable to the discontinuous openings 214 and, for the sake of brevity, are not repeated. Furthermore, descriptions provided for the edge regions 196 of the glass core 110 are applicable to the descriptions of the edge regions of the glass panel 182. In particular, descriptions of dimensions and locations of the edge regions 196 provided with respect to the glass core 110 are applicable to dimensions and locations of the edge regions with respect to the glass panel 182.

FIGS. 12A-12C provide cross-sectional side views of glass cores 110 illustrating different examples of edge features in the form of openings filled with self-healing agents/materials, according to some embodiments of the present disclosure. Such openings may be referred to as "self-healing openings" and are shown as self-healing openings 222 in FIGS. 12A-12C. As used herein, "self-healing" refers to the ability of a material to at least partially repair its damage autonomously and retain its structural integrity. To that end, nanomaterials and nanostructures in polymers provide large surface area, rich functional groups, and unique properties that may facilitate the healing process in glass. Thus, in some embodiments, the self-healing openings 222 may include a matrix 224 in which self-healing particles 226 may be dispersed. The matrix 224 may include any suitable polymer, such as epoxy. In some embodiments, the matrix 224 may include a thermoset, i.e., a type of polymer that, once formed, undergoes a chemical reaction that irreversibly solidifies or "sets" the material. In some embodiments, such a process may be induced by heat, catalysts, or a combination of both. A thermoset may include one or more polymer materials such as phenolics, alkyds, vinyl esters, unsaturated polyesters, polyurethanes, or aminoplastics. The self-healing particles 226 may include any suitable nanomaterials or nanostructures, e.g., microcapsules or nanocapsules, filled with a healing agent. The healing agent may include materials such as poly (urea-formaldehyde) (PUF), polyurethane, poly (melamine-urea-formaldehyde) (PMUF), or poly (melamine-formaldehyde) (PMF). The polymerization and/or crosslinking of the healing agent, possibly in presence of the catalyst, may mend the cracked area and arrest further growth of the crack. If used, catalysts may include materials such as Hoveyda - Grubbs catalysts. In some embodiments, catalysts may include ruthenium. In some embodiments, catalysts may be dispersed in the glass core 110 and not in the self-healing openings 222. Upon crack growth, the microcapsules or nanocapsules of the self-healing particles 226 may be ruptured and may release the healing agent into the crack in the glass core 110. The healing agent would then contact the catalyst dispersed in the glass core 110, which would initiate polymerization/crosslinking of the healing agent, thereby filling the crack. In other embodiments, catalysts may be coated on the edges 194 of the glass core 110 and/or coated on the sidewalls of the self-healing openings 222. In still other embodiments, catalysts may be coated on the outer shell of the self-healing particles 226. In all of these embodiments, upon crack growth, the microcapsules or nanocapsules of the self-healing particles 226 may be ruptured and the healing agent would contact the catalyst, which would initiate polymerization/crosslinking of the healing agent and at least partially fill the crack. Breaking a polymer may involve the rupture of chemical and physical bonds, and the reformation of these bonds results in self-healing. Self-healing through chemical approaches may utilize dynamic covalent bonds from reactions such as Diels-Alder reaction and disulfide bond formation, while self-healing through physical approaches may utilize intermolecular interactions like hydrogen bonds. Incorporating nanomaterials in self-healing systems may advantageously provide large interfacial surface area, enhanced electrical and mechanical properties, improved response to external stimuli, and increased conversion efficiency of electromagnetic energy to heat.

FIG. 12A illustrates an embodiment where the self-healing openings 222 are TGVs filled with the matrix 224 and the self-healing particles 226. FIG. 12B illustrates an embodiment where the self-healing openings 222 filled with the matrix 224 and the self-healing particles 226 may further include an opening 228 filled with a material such as a metal (e.g., copper) or a fill material 204 as described above. FIG. 12C illustrates an embodiment where the self-healing openings 222 may include self-healing openings 222-1 and self-healing openings 222-2. The self-healing openings 222-1 are provided at the first face 190-1 of the glass core 110 and extend towards, but do not reach, the second face 190-2. The self-healing openings 222-2 are provided at the second face 190-2 of the glass core 110 and extend towards, but do not reach, the first face 190-1.

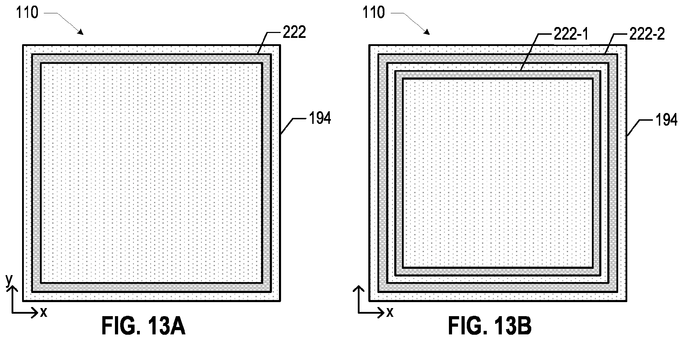

The self-healing openings 222 shown in FIG. 12A and 12B are shown as vias that extend all the way through the thickness of the glass core 110, while the self-healing openings 222 shown in FIG. 12C are shown as blind vias. All of the descriptions provided above with respect to the discontinuous openings 212 are applicable to the self-healing openings 222. Phrased differently, in further embodiments of FIGS. 8-11, the discontinuous openings 212 may be at least partially filled with self-healing materials as described for the self-healing openings 222, instead of the fill material 204. All of the descriptions provided above with respect to the trenches 202 are applicable to the self-healing openings 222. Phrased differently, in further embodiments of FIGS. 5-7, the trenches 202 may be at least partially filled with self-healing materials as described for the self-healing openings 222, instead of the fill material 204. FIGS. 13A-13B provide further illustrations of the self-healing openings 222 being implemented as trenches that may be filled with self-healing materials. FIG. 13A illustrates a self-healing opening 222 being a single continuous trench proximate to the edges 194. For example, such a trench may be similar to the trench 202-2 described above, although it may extend all the way through the thickness of the glass core 110 in some embodiments. FIG. 13B illustrates the self-healing openings 222 being two continuous trenches proximate to the edges 194. For example, the outer trench (i.e., the one closer to the edges 194), labeled in FIG. 13B as a self-healing opening 222-2, may be similar to the trench 202-2 described above, although it may extend all the way through the thickness of the glass core 110 in some embodiments. The inner trench (i.e., the one further away from the edges 194), labeled in FIG. 13B as a self-healing opening 222-1, may be similar to the trench 202-1 described above, although it may also extend all the way through the thickness of the glass core 110 in some embodiments.

Turning to edge features based on reducing crack formation in glass cores 110, FIGS. 14A-14B provide top-down views of glass panels 182 illustrating different examples of edge features in the form of discontinuous openings 232 along the saw streets 184, according to some embodiments of the present disclosure. As described above, singulation process causes crack formation and damage of glass cores, in particular if singulation is performed after the build-up layers have been formed on top and/or bottom of the glass. In the past, mitigation plans have been proposed to address this problem by optimizing the singulation process, including development of new equipment or cutting techniques, or by changing the build-up material types. Such solutions take a long time to fully develop and are very costly. An alternative proposed herein is based on the recognition that if discontinuous openings 232 are first created along the saw streets 184 and filled with a fill material 234, prior to the formation of build-up layers around the glass, then the effective area of glass being cut during singulation will be reduced, reducing the chances of crack formation. In some embodiments, the discontinuous openings 232 may be vias, as shown in FIG. 14A. In other embodiments, the discontinuous openings 232 may be trenches, as shown in FIG. 14B. Formation of the discontinuous openings 232 is a much gentler process than singulation because the openings 232 may be formed using processes such as dry etching, wet etching, or laser modification followed by wet etching. The fill material 234 may include any of the materials described with reference to the fill material 204. In various embodiments, the fill material 234 may fill the discontinuous openings 232 either partially or fully. Further considerations regarding the amount of the fill material 204 in the trenches 202, provided above, are applicable to filling the discontinuous openings 232 with the fill material 234 and, for the sake of brevity, are not repeated. The discontinuous openings 232 may extend all the way through the thickness of the glass core 110, i.e., extend between the first face 190-1 and the second face 190-2, e.g., as shown in the cross-sectional side views (x-z plane) at the bottom of FIGS. 14A-14B. The cross-sectional side views shown in FIGS. 14A-14B are cross-sections along the planes AA shown in the top-down views of FIGS. 14A-14B. Once the discontinuous openings 232 have been formed along the saw streets 184 and filled with the fill material 234, any conventional process may then be applied to provide the build-up layers, followed by any conventional process of singulation. In the final glass cores 110 resulting from such a process, portions of the discontinuous openings 232 with the fill material 234 may be detectable along the edges 194.

Turning to the last category of edge features, namely, edge features based on reducing edge stress in glass cores 110, FIGS. 15-18 illustrate examples of edge features in the form of anchors.

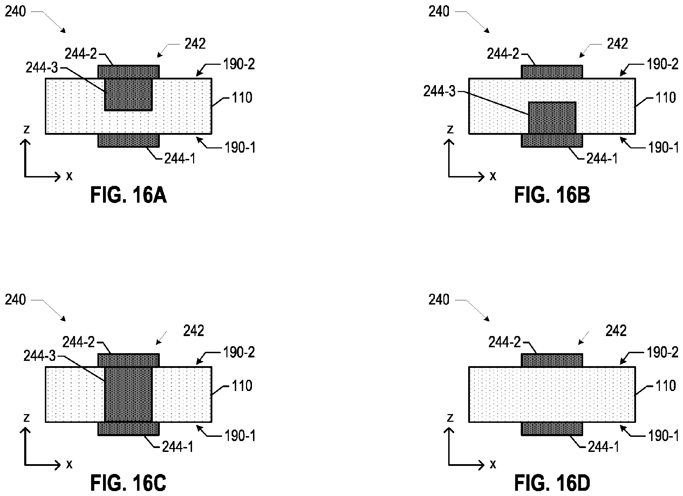

FIGS. 15A-15B provide top-down views of glass cores 110 illustrating different examples of edge features in the form of continuous (FIG. 15A) and discontinuous (FIG. 15B) anchors 242 in the edge regions 196 of a glass core 110, according to some embodiments of the present disclosure. In FIGS. 15A-15B, a dashed contour illustrates a portion 240 of the glass core 110 for which various examples of cross-sectional side views are shown in FIGS. 16A-16D, according to some embodiments of the present disclosure. As shown in FIGS. 16A-16D, an anchor 242 may include a first portion 244-1 on the first face 190-1 of the glass core 110, a second portion 244-2 on the second face 190-2 of the glass core 110, and, in some embodiments, also a third portion 244-3 embedded in the glass core 110 (e.g., between the first face 190-1 and the second face 190-2). Collectively, any two or more of the portions 244-1, 244-2, and 244-3 may be referred to as "portions 244." In some embodiments, a dimension of the first and/or second portions 244-1 and/or 244-2 in a direction perpendicular to the nearest edge 194 may be larger than a dimension of the third portion 244-3. The portions 244 of the anchors 242 may be, or may include, a metal, e.g., copper, or any other suitable material that may counteract the stresses imposed on the glass core 110, e.g., to counteract stresses imposed by the CTE mismatch of the dielectric material of the build-up layers later placed on top and/or the bottom of the glass core 110.

The portions 244 of the anchors 242 may be arranged in any suitable manner that could help hold the glass core 110 together, reduce direct edge stress in the glass core 110, and/or prevent the glass core 110 from splitting. In some embodiments, the third portion 244-3 may be attached to (e.g., may be materially continuous with) the second portion 244-2, as shown in FIG. 16A. In other embodiments the third portion 244-3 may be attached to (e.g., may be materially continuous with) the first portion 244-1, as shown in FIG. 16B. In still other embodiments, the third portion 244-3 may extend through the thickness of the glass core 110 and be attached to (e.g., may be materially continuous with) both the first portion 244-1 and the second portion 244-2, as shown in FIG. 16C. Yet in other embodiments, an anchor 242 may have the first and second portions 244-1, 244-2, but not include the third portion 244-3, as shown in FIG. 16D. FIGS. 15A and 15B illustrate that the anchors 242 may extend at the periphery of a glass core 110, e.g., extend along the edges 194, in the edge regions 196 of the glass core 110. In some embodiments, an anchor 242 may extend as a continuous anchor around at least one of the edges 194 (e.g., the anchor 242 at one of the edges 194 of FIG. 15A), or as a continuous anchor around two or more of the edges 194 (e.g., the anchor 242 extending continuously along all of the edges 194, as shown in FIG. 15A). In such embodiments, a continuous anchor 242 may extend similar to the trenches 202 or the embodiment of continuous self-healing openings 222 described above. In other embodiments, an anchor 242 may also extend along at least one of the edges 194 but in a discontinuous form, as shown in FIG. 15B. In such embodiments, a discontinuous anchor 242 may extend similar to the discontinuous openings 212 or the embodiment of discontinuous self-healing openings 222 described above. In some embodiments, a dimension of the anchor 242 along the direction parallel to the nearest edge 194 may be larger than a dimension of the anchor 242 along the direction perpendicular to the nearest edge 194. In various embodiments, any of the anchors 242 implemented as continuous anchors or discontinuous anchors may include a combination of the cross-sectional profiles shown in FIGS. 16A-16D. For example, in some embodiments, a single continuous portion of an anchor 242 (either an anchor 242 along an entire edge 194 as shown in FIG. 15A or a continuous portion of an anchor 242 along a portion of the edge 194 as shown in FIG. 15B) may include a continuous first portion 244-1 and a continuous second portion 244-2, but the third portion 244-3 may vary along the length of the continuous portion of the anchor 242 between two or more variations of the third portion 244-3 as shown in FIGS. 16A-16D.

While FIGS. 15A-15B and FIGS. 16A-16D illustrate the anchors 242 in the edge regions 196 of a glass core 110, the anchors 242 as described herein may also be provided in the edge regions of a glass panel 182 (e.g., around multiple glass cores 110). Thus, the anchors 242 as described herein may be provided as continuous or discontinuous anchors 242 in the periphery (i.e., in the edge regions) of a glass panel 182 that includes two or more individual glass units 186 or individual glass cores 110.

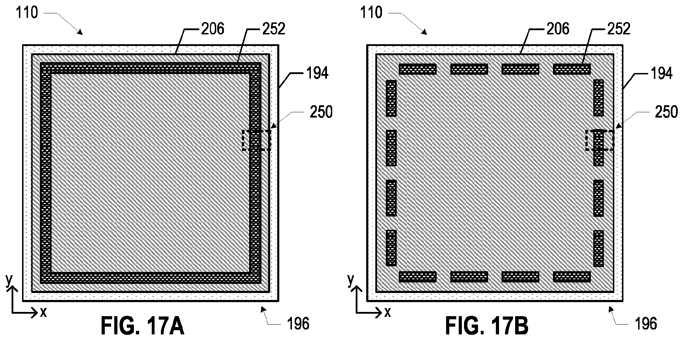

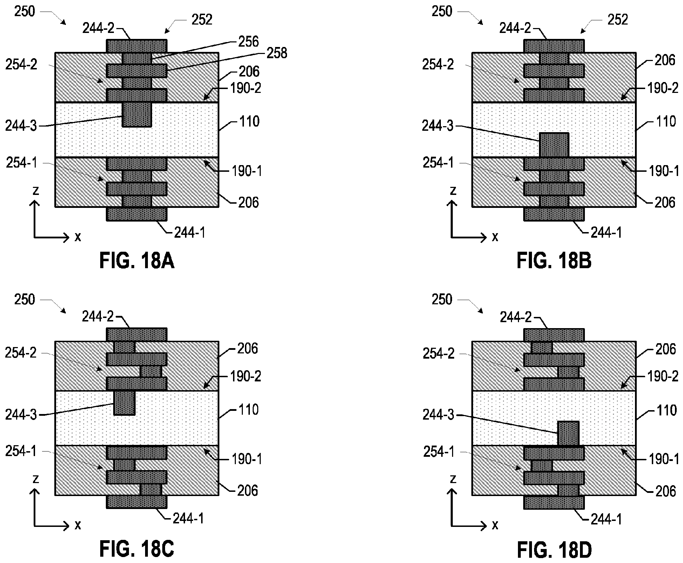

FIGS. 17A-17B provide top-down views of glass cores 110 illustrating different examples of edge features in the form of continuous (FIG. 17A) and discontinuous (FIG. 17B) anchors 252 in the edge regions 196 of a glass core 110, extending through build-up layers 206, according to some embodiments of the present disclosure. In FIGS. 17A-17B, a dashed contour illustrates a portion 250 of the glass core 110 for which various examples of cross-sectional side views are shown in FIGS. 18A-18D, according to some embodiments of the present disclosure. The anchors 252 are similar to the anchors 242 in that they include the portions 244-1, 244-2, and 244-3 as described above, except that the first portion 244-1 of the anchors 252 is provided on top of the build-up layer 206 over the first face 190-1 of the glass core, and the second portion 244-2 of the anchors 252 is provided on top of the build-up layer 206 over the second face 190-2 of the glass core. As shown in FIGS. 18A-18D, an anchor 252 may include a first portion 244-1 over the build-up layer 206 on the first face 190-1 of the glass core 110, a second portion 244-2 over the build-up layer 206 on the second face 190-2 of the glass core 110, and a third portion 254-3 embedded in the glass core 110 (e.g., between the first face 190-1 and the second face 190-2). As further shown in FIGS. 18A-18D, an anchor 252 may further include a first build-up portion 254-1 extending through the build-up layer 206 on the first face 190-1 of the glass core 110, and a second build-up portion 254-2 extending through the build-up layer 206 on the second face 190-2 of the glass core 110. The first build-up portion 254-1 may be attached to (e.g., may be materially continuous with) the first portion 244-1, while the second build-up portion 254-2 may be attached to (e.g., may be materially continuous with) the second portion 244-2. Collectively, the portions 254-1 and 254-2 may be referred to as "portions 254." Similar to the portions 244, the portions 254 of the anchors 252 may be, or may include, a metal, e.g., copper, or any other suitable material that may counteract the stresses imposed on the glass core 110, e.g., to counteract stresses imposed by the CTE mismatch of the dielectric material of the build-up layers later placed on top and/or the bottom of the glass core 110.

The portions 244 and 254 of the anchors 252 may be arranged in any suitable manner that could help hold the glass core 110 together, reduce direct edge stress in the glass core 110, and/or prevent the glass core 110 from splitting. In some embodiments, the third portion 244-3 may be attached to (e.g., may be materially continuous with) the second build-up portion 254-2, as shown in FIG. 18A and FIG. 18C. In other embodiments the third portion 244-3 may be attached to (e.g., may be materially continuous with) the first portion 254-1, as shown in FIG. 18B and FIG. 18D. In still other embodiments, the third portion 254-3 may extend through the thickness of the glass core 110 and be attached to (e.g., may be materially continuous with) both the first portion 254-1 and the second portion 254-2 (not specifically shown in FIGS. 18A-18D but as was shown in FIG. 16C). Yet in other embodiments, an anchor 252 may have the first and second portions 254-1, 254-2, but not include the third portion 244-3 (also not specifically shown in FIGS. 18A-18D but as was shown in FIG. 16D). In some embodiments, an individual portion 254 may include a plurality of vias 256 and pads 258 in different sub-layers of a build-up layer 206. One of such vias 256 and one of such pads 258 are labeled in FIG. 18A but not individually labeled in FIGS. 18B-18D in order to not clutter the drawings. The division of the portion 254 into vias 256 and pads 258 may be due to the fact that, in some embodiments, these portions of the portion 254 may be formed layer by layer as different sub-layers of a build-up layer 206 are formed, similar to the formation of conductive vias and conductive traces in various layers. In some embodiments, different ones of the vias 256 and pads 258 of a given portion 254 may be substantially stacked over one another (e.g., arranged in a symmetric manner), as is shown in FIG. 18A and FIG. 18B, while, in other embodiments, different ones of the vias 256 and pads 258 of a given portion 254 may be staggered, as is shown in FIG. 18C and FIG. 18D.

FIGS. 17A and 17B illustrate that the anchors 252 may extend at the periphery of a glass core 110, e.g., extend along the edges 194, in the edge regions 196 of the glass core 110. In some embodiments, an anchor 252 may extend as a continuous anchor around at least one of the edges 194 (e.g., the anchor 252 at one of the edges 194 of FIG. 17A), or as a continuous anchor around two or more of the edges 194 (e.g., the anchor 252 extending continuously along all of the edges 194, as shown in FIG. 17A). In such embodiments, a continuous anchor 252 may extend similar to the trenches 202 or the embodiment of continuous self-healing openings 222 described above. In other embodiments, an anchor 252 may also extend along at least one of the edges 194 but in a discontinuous form, as shown in FIG. 17B. In such embodiments, a discontinuous anchor 252 may extend similar to the discontinuous openings 212 or the embodiment of discontinuous self-healing openings 222 described above. For the embodiments when an anchor 252 is a discontinuous anchor, a dimension of the anchor 252 along the direction parallel to the nearest edge 194 may be larger than a dimension of the anchor 252 along the direction perpendicular to the nearest edge 194. In various embodiments, any of the anchors 252 implemented as continuous anchors or discontinuous anchors may include a combination of the cross-sectional profiles shown in FIGS. 18A-18D. For example, in some embodiments, a single continuous portion of an anchor 252 (either an anchor 252 along an entire edge 194 as shown in FIG. 17A or a continuous portion of an anchor 252 along a portion of the edge 194 as shown in FIG. 17B) may include a continuous first portion 244-1 and a continuous second portion 244-2, but the third portion 244-3 may vary along the length of the continuous portion of the anchor 252 between two or more variations of the third portion 244-3 as shown in FIGS. 18A-18D. In another example, in some embodiments, a single continuous portion of an anchor 252 (either an anchor 252 along an entire edge 194 as shown in FIG. 17A or a continuous portion of an anchor 252 along a portion of the edge 194 as shown in FIG. 17B) may include a continuous first portion 244-1 and a continuous second portion 244-2, but the first build-up portion 254-1 and/or the second build-up portion 254-2 may vary along the length of the continuous portion of the anchor 252 between stacked and staggered and staggered variations of the first build-up portion 254-1 and/or the second build-up portion 254-2 as shown in FIGS. 18A-18D.

While FIGS. 17A-17B and FIGS. 18A-18D illustrate the anchors 252 in the edge regions 196 of a glass core 110, the anchors 252 as described herein may also be provided in the edge regions of a glass panel 182 (e.g., around multiple glass cores 110). Thus, the anchors 252 as described herein may be provided as continuous or discontinuous anchors 252 in the periphery (i.e., in the edge regions) of a glass panel 182 that includes two or more individual glass units 186 or individual glass cores 110.

Another example of edge features based on reducing edge stress in glass cores 110 is shown in FIGS. 19-20, illustrating edge features in the form of daisy chain rings.

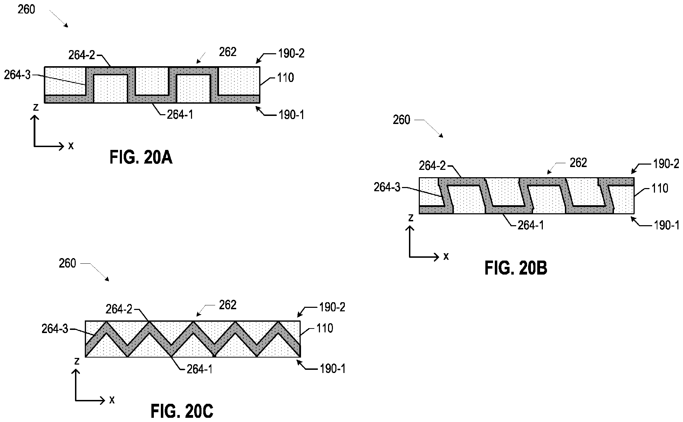

FIGS. 19A-19B provide top-down views of glass panels 182 illustrating different examples of edge features in the form of daisy chain rings 262, according to some embodiments of the present disclosure. FIG. 19A illustrates a single daisy chain ring 262 extending continuously along the edges 194 (e.g., in the edge regions 196) of individual glass units 186 which will later form glass cores 110. FIG. 19B illustrates that, in some embodiments, multiple daisy chain rings 262 may be nested along the edges 194, shown as a first daisy chain ring 262-1 and a second daisy chain ring 262-2 around the first daisy chain ring 262-1. Thus, the second daisy chain ring 262-2 may be an outer ring (i.e., a ring closest to the edges 194), while the first daisy chain ring 262-1 may be an inner ring (i.e., a ring further away from the edges 194 but still within the edge regions 196 as described above). In other embodiments, more than two daisy chain rings 262 may be nested within one another. A dashed contour shown in FIG. 19A illustrates a portion 260 of the glass core 110 for which various examples of cross-sectional side views with cross-sections taken along the daisy chain ring 262 are shown in FIGS. 20A-20C, according to some embodiments of the present disclosure. Any of one or more daisy chain rings 262 along the edges 194 of a glass core 110 may take on the form of any of FIGS. 20A-20C.

As shown in FIGS. 20A-20C, a daisy chain ring 262 may include a first portion 264-1 in a recess in the first face 190-1 of the glass core 110, a second portion 264-2 in a recess in the second face 190-2 of the glass core 110, and a third portion 264-3 embedded in the glass core 110 (e.g., between the first face 190-1 and the second face 190-2) and connecting the first portions 264-1 and the second portions 264-2 in a daisy chain fashion. Collectively, any two or more of the portions 264-1, 264-2, and 264-3 may be referred to as "portions 264." In some embodiments, the portions 264 of the daisy chain rings 262 may be, or may include, a metal, e.g., copper, or any other suitable material that may counteract the stresses imposed on the glass core 110, e.g., to counteract stresses imposed by the CTE mismatch of the dielectric material of the build-up layers later placed on top and/or the bottom of the glass core 110. In other embodiments, the portions 264 may include any of the materials described with reference to the fill material 204. FIG. 20A illustrates an embodiment where the third portions 264-3 are substantially perpendicular to the faces 190 of the glass core 110. FIG. 20B illustrates an embodiment where the third portions 264-3 are angled (i.e., at an angle other than 90 degree) with respect to the faces 190 of the glass core 110. FIG. 20C illustrates an embodiment where the third portions 264-3 are angled with respect to the faces 190 of the glass core 110 and where the first and second portions 264-1, 264-2 just touch the respective first and second faces 190-1, 190-2. In various other embodiments, the pitch, depth, and width of different portions 264 of the daisy chain ring 262 may be modified as desired. When multiple daisy chain rings 262 are implemented around the active area of the glass core 110, the size, pitch, stitching pattern, etc., can vary between each pair of daisy chain rings 262

Yet another example of edge features based on reducing edge stress in glass cores 110 is shown in FIGS. 21-22, illustrating edge features in the form of edge clamps.

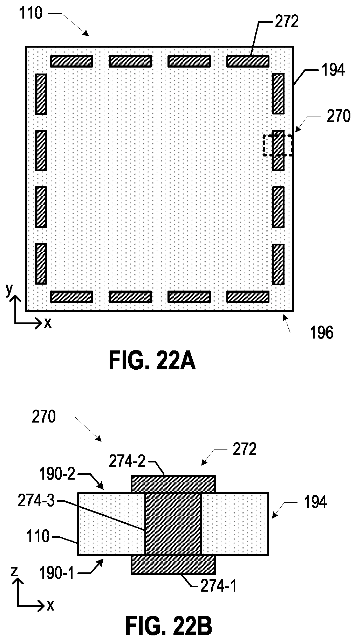

FIGS. 21A-21B provide top-down and cross-sectional side views of glass cores 110 illustrating a first example of edge features in the form of edge clamps 272, according to some embodiments of the present disclosure. FIGS. 22A-22B provide top-down and cross-sectional side views of glass cores 110 illustrating a second example of edge features in the form of edge clamps 272, according to some embodiments of the present disclosure. In FIGS. 21A and 22A, a dashed contour illustrates a portion 270 of the glass core 110 for which examples of cross-sectional side views are shown, respectively, in FIGS. 21B and 22B, according to some embodiments of the present disclosure. As shown in FIG. 21A, in some embodiments, the edge clamp 272 may extend around all edges 194 of the glass core 110. However, in other embodiments, the edge clamp 272 may extend only around one of the edges 194, or around two or more of the edges 194 but not all of the edges 194. In some embodiments, the edge clamp 272 may extend along at least 50% of a length of a given edge 194. In some embodiments, the edge clamp 272 may extend along the entire length of a given edge 194. In still other embodiments, the edge clamp 272 may be one of a plurality of edge clamps 272 along a given edge 194, the plurality of edge clamps 272 being material discontinuous from one another (e.g., similar to the discontinuous openings 232 along the saw streets 184).

FIG. 21B illustrates that an edge clamp 272 may wrap around the edges 194 in that it may have a first portion 274-1 on the first face 190-1 of the glass core 110, a second portion 274-2 on the second face 190-2 of the glass core 110, and a third portion 274-3 on the edge 194, connecting the first portion 274-1 and the second portion 274-2. Collectively, any two or more of the portions 274-1, 274-2, and 274-3 may be referred to as "portions 274." In some embodiments, adjacent ones of the portions 274 may be materially continuous with one another (e.g., one end of the third portion 274-3 may be materially continuous with the first portion 274-1, and another end of the third portion 274-3 may be materially continuous with the second portion 274-2). As shown in FIG. 22A, in other embodiments, the edge clamp 272 may extend along the edges 194 but inset from the edges 194, within the edge regions 196. FIG. 22B illustrates that such an edge clamp 272 may also have a first portion 274-1 on the first face 190-1 of the glass core 110, a second portion 274-2 on the second face 190-2 of the glass core 110, and a third portion 274-3 embedded between the first face 190-1 and the second face 190-2, extending between the first portion 274-1 and the second portion 274-2. The edge clamp 272 of FIGS. 22A-22B may be similar to the discontinuous anchors 242 shown in FIG. 15B, except for the material of the edge clamp 272. In both FIG. 21 and FIG. 22, the edge clamps 272 may be made of a negative CTE material (i.e., a material that contracts when heated and expands when cooled). Some example of negative CTE materials that may be used to implement the edge clamps 272 include zirconium tungstate (ZrW2O8), gallium arsenide (GaAs), copper oxide (Cu2O), or certain polymers such as liquid crystalline polymers (e.g., poly(p-phenylene benzobisoxazole) (PBO or Zylon)). The negative CTE materials may act as a "clamp" to counteract stresses which induce crack formation and propagation because negative CTE of these materials opposes direction of stresses by contracting rather than expanding under thermal stress.

While FIGS. 21A-21B and FIGS. 22A-22B illustrate the edge clamps 272 in the edge regions 196 of a glass core 110, the edge clamps 272 as described herein may also be provided in the edge regions of a glass panel 182 (e.g., around multiple glass cores 110). Thus, the edge clamps 272 as described herein may be provided as continuous or discontinuous edge clamps 272 in the periphery (i.e., in the edge regions) of a glass panel 182 that includes two or more individual glass units 186 or individual glass cores 110.

Various edge features described above may, advantageously, be easily fabricated in parallel with conventional manufacturing techniques for glass core substrates. Various arrangements of the microelectronic assemblies 100 and glass cores 110 as shown in FIGS. 1-22 do not represent an exhaustive set of microelectronic assemblies and glass cores in which various edge features as described herein may be used, but merely provide some illustrative examples. In particular, the number and positions of various elements shown in FIGS. 1-22 is purely illustrative and, in various other embodiments, other numbers of these elements, provided in other locations relative to one another may be used in accordance with the general architecture considerations described herein. For example, although not specifically shown in the present drawings, in some embodiments, a microelectronic assembly 100 may include a redistribution layer (RDL) between any pair of layers shown in FIG. 1 and FIG. 2, the RDL including a plurality of interconnect structures (e.g., conductive lines and conductive vias) to assist routing of signals and/or power between components. In another example, although also not specifically shown in the present drawings, in some embodiments, a package substrate 102 of a microelectronic assembly 100 may include one or more recesses. In such embodiments, a bottom face of a recess in the package substrate 102 may be provided by the solid material of the package substrate 102. A recess may be formed in a package substrate 102 in any suitable manner (e.g., via three-dimensional printing, laser cutting or drilling the recess into an existing package substrate, etc.). At least a portion of the substrate 107 or the glass core 110 may be positioned over or at least partially in such a recess. In yet another example, features of any one of FIGS. 1-22 may be combined with features of any other one of FIGS. 1-22.

The microelectronic assemblies 100 and/or the glass cores 110 disclosed herein, in particular the glass cores 110 with one or more edge features as described herein, may be included in any suitable electronic component. FIGS. 23-26 illustrate various examples of apparatuses that may include, or be included in, any of the microelectronic assemblies 100 and/or the glass cores 110 disclosed herein.

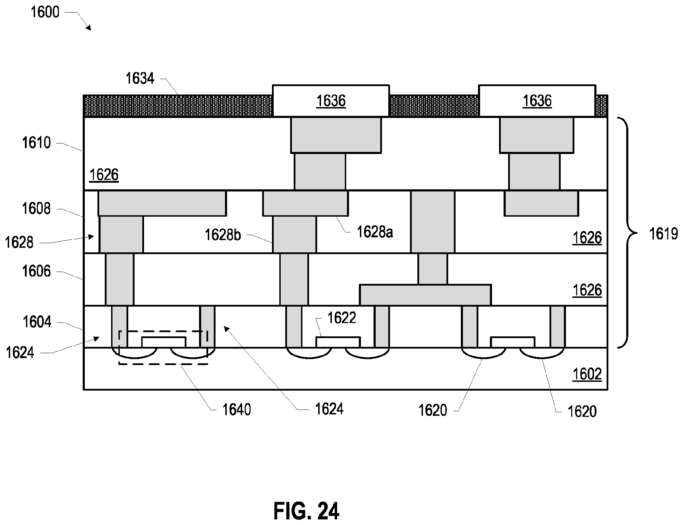

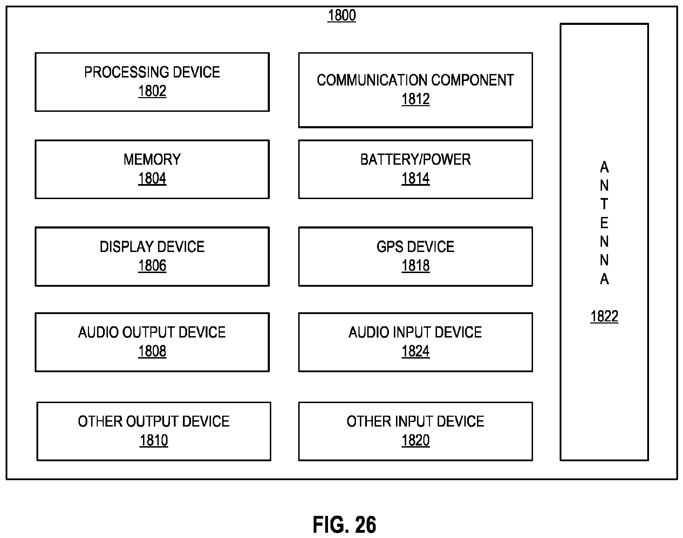

FIG. 23 is a top view of a wafer 1500 and dies 1502 that may be included in any of the microelectronic assemblies 100 as described herein. For example, a die 1502 may be any of the dies 114 described herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 24, discussed below) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 26) or other logic that is configured to store information in the memory devices or execute instructions stored in the memory array.

FIG. 24 is a side, cross-sectional view of an IC device 1600 that may be included in any of the microelectronic assemblies 100 as described herein. For example, an IC device 1600 may be provided on/in any of the dies 114 described herein. The IC device 1600 may be formed on a substrate 1602 (e.g., the wafer 1500 of FIG. 23) and may be included in a die (e.g., the die 1502 of FIG. 23). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group III-V materials (i.e., materials from groups III and V of the periodic system of elements), group II-VI (i.e., materials from groups II and IV of the periodic system of elements), or group IV materials (i.e., materials from group IV of the periodic system of elements) may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 23) or a wafer (e.g., the wafer 1500 of FIG. 23).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 24 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top face of the substrate. In other embodiments, at least one of the metal layers that form the gate electrode may simply be a planar layer that is substantially parallel to the top face of the substrate and does not include sidewall portions substantially perpendicular to the top face of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 24 as interconnect layers 1606, 1608, and 1610). For example, electrically conductive features of the device layer 1604 (e.g., the gate 1622 and the S/D contacts 1624) may be electrically coupled with the interconnect structures 1628 of the interconnect layers 1606, 1608, and 1610. The one or more interconnect layers 1606, 1608, and 1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 24). Although a particular number of interconnect layers 1606, 1608, and 1610 is depicted in FIG. 24, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 24. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606, 1608, and 1610 together.

The interconnect layers 1606, 1608, and 1610 may include a dielectric material 1626 disposed between the interconnect structures 1628, as shown in FIG. 24. In some embodiments, the dielectric material 1626 disposed between the interconnect structures 1628 in different ones of the interconnect layers 1606, 1608, and 1610 may have different compositions; in other embodiments, the composition of the dielectric material 1626 between different interconnect layers 1606, 1608, and 1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606, 1608, and 1610. In FIG. 24, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606, 1608, and 1610; for example, the conductive contacts 1636 may include other analogous features (e.g., posts) that route the electrical signals to external components.

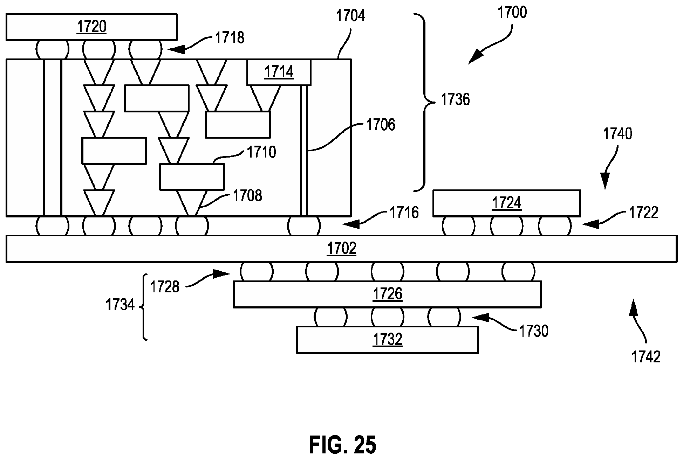

FIG. 25 is a side, cross-sectional view of an IC device assembly 1700 that may include a glass core with one or more edge features in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the microelectronic assemblies 100 discussed above, e.g., may include one or more microelectronic assemblies 100 as discussed with reference to FIG. 1 and FIG. 2, and/or may include one or more glass cores as discussed with reference to FIGS. 3-22.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 25 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 25), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 25, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 5), an IC device (e.g., any of the IC devices described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of ball grid array (BGA) conductive contacts of the coupling components 1716 for coupling to the circuit board 1702. In the embodiment illustrated in FIG. 25, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a glass core with one or more edge features, e.g., as any embodiment of the glass core 110, described herein. In some embodiments, the package interposer 1704 may be formed as a PCB. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. In any of these embodiments, the package interposer 1704 may include multiple metal layers separated from one another by layers of dielectric material and interconnected by electrically conductive vias. The package interposer 1704 may include metal lines 1710 and vias 1708, including but not limited to conductive vias 1706. If the package interposer 1704 is a glass core, e.g., the glass core 110 as described herein, then the conductive vias 1706 may be TGVs 115 as described herein. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 25 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 26 is a block diagram of an example communication device 1800 that may include one or more microelectronic assemblies 100 and/or one or more glass cores 110 in accordance with any of the embodiments disclosed herein. A handheld communication device or a laptop communication device may be examples of the communication device 1800. Any suitable ones of the components of the communication device 1800 may include one or more of the microelectronic assemblies 100, IC packages 1720, 1724, IC device assemblies 1700, IC devices 1600, or dies 1502 disclosed herein. In particular, any suitable ones of the components of the communication device 1800 may include one or more glass cores 110 as described herein, e.g., as a part of a microelectronic assembly 100 as described herein. A number of components are illustrated in FIG. 26 as included in the communication device 1800, but any one or more of these components may be omitted or duplicated, as suitable for the application. In some embodiments, some or all of the components included in the communication device 1800 may be attached to one or more motherboards. In some embodiments, some or all of these components are fabricated onto a single system-on-a-chip (SoC) die.

Additionally, in various embodiments, the communication device 1800 may not include one or more of the components illustrated in FIG. 26, but the communication device 1800 may include interface circuitry for coupling to the one or more components. For example, the communication device 1800 may not include a display device 1806, but may include display device interface circuitry (e.g., a connector and driver circuitry) to which a display device 1806 may be coupled. In another set of examples, the communication device 1800 may not include an audio input device 1824 or an audio output device 1808, but may include audio input or output device interface circuitry (e.g., connectors and supporting circuitry) to which an audio input device 1824 or audio output device 1808 may be coupled.

The communication device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The communication device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic RAM (STT-MRAM).

In some embodiments, the communication device 1800 may include a communication module 1812 (e.g., one or more communication modules). For example, the communication module 1812 may be configured for managing wireless communications for the transfer of data to and from the communication device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication module 1812 may be, or may include, any of the microelectronic assemblies 100 disclosed herein.

The communication module 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication module 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication module 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication module 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication module 1812 may operate in accordance with other wireless protocols in other embodiments. The communication device 1800 may include an antenna 1822 to facilitate wireless communications and/or to receive other wireless communications (such as AM or FM radio transmissions). The antenna 1822 may include one or more microelectronic assemblies 100 and/or one or more glass cores 110 as described herein, e.g., as a part of a microelectronic assembly 100 as described herein.

In some embodiments, the communication module 1812 may manage wired communications, such as electrical, optical, or any other suitable communication protocols (e.g., the Ethernet). As noted above, the communication module 1812 may include multiple communication modules. For instance, a first communication module 1812 may be dedicated to shorter-range wireless communications such as Wi-Fi or Bluetooth, and a second communication module 1812 may be dedicated to longer-range wireless communications such as global positioning system (GPS), EDGE, GPRS, CDMA, WiMAX, LTE, EV-DO, or others. In some embodiments, a first communication module 1812 may be dedicated to wireless communications, and a second communication module 1812 may be dedicated to wired communications. In some embodiments, the communication module 1812 may support millimeter wave communication.

The communication device 1800 may include battery/power circuitry 1814. The battery/power circuitry 1814 may include one or more energy storage devices (e.g., batteries or capacitors) and/or circuitry for coupling components of the communication device 1800 to an energy source separate from the communication device 1800 (e.g., AC line power).

The communication device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The communication device 1800 may include an audio output device 1808 (or corresponding interface circuitry, as discussed above). The audio output device 1808 may include any device that generates an audible indicator, such as speakers, headsets, or earbuds.

The communication device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The communication device 1800 may include a GPS device 1818 (or corresponding interface circuitry, as discussed above). The GPS device 1818 may be in communication with a satellite-based system and may receive a location of the communication device 1800, as known in the art.

The communication device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The communication device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The communication device 1800 may have any desired form factor, such as a handheld or mobile communication device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop communication device, a server or other networked computing component, a printer, a scanner, a monitor, a set-top box, an entertainment control unit, a vehicle control unit, a digital camera, a digital video recorder, or a wearable communication device. In some embodiments, the communication device 1800 may be any other electronic device that processes data.

The following paragraphs provide examples of various ones of the embodiments disclosed herein.

Example 1 provides a microelectronic assembly that includes a glass core (e.g., a layer of glass including a rectangular prism volume) having a first face, a second face opposite the first face, an edge between an end of the first face and an end of the second face, and an edge region extending from the edge into the glass core by a distance that is less than about 10% (e.g., less than about 5% or less than about 1%) of a width of the glass core (the width being measured in a direction that is substantially parallel to the first face and perpendicular to a line where the edge meets the first face); and an opening in the edge region, the opening extending from the first face towards the second face and including a fill material.

Example 2 provides the microelectronic assembly according to example 1, where the fill material includes an organic insulator material.

Example 3 provides the microelectronic assembly according to examples 1 or 2, where the fill material includes an inorganic insulator material.

Example 4 provides the microelectronic assembly according to any one of the preceding examples, where the fill material includes a polymer.

Example 5 provides the microelectronic assembly according to any one of the preceding examples, where the fill material includes ABF.

Example 6 provides the microelectronic assembly according to any one of the preceding examples, where a Young's modulus of the fill material is smaller than about 10 GPa.

Example 7 provides the microelectronic assembly according to any one of the preceding examples, where a Poisson's ratio of the fill material is smaller than about 0.25.

Example 8 provides the microelectronic assembly according to any one of the preceding examples, where a CTE of the fill material is smaller than about 15 ppm/K, e.g., smaller than about 10 ppm/K or smaller than about 5 ppm/K.

Example 9 provides the microelectronic assembly according to any one of the preceding examples, where the fill material includes an electrically conductive material.

Example 10 provides the microelectronic assembly according to any one of the preceding examples, where the fill material includes a metal.

Example 11 provides the microelectronic assembly according to any one of the preceding examples, where the fill material includes a self-healing material.

Example 12 provides the microelectronic assembly according to example 11, where the self-healing material includes a matrix material and particles dispersed in the matrix material, the particles containing a self-healing agent.

Example 13 provides the microelectronic assembly according to example 12, where the self-healing material includes a polymer.

Example 14 provides the microelectronic assembly according to examples 12 or 13, where the self-healing agent includes poly (urea-formaldehyde) (PUF), polyurethane, poly (melamine-urea-formaldehyde) (PMUF), or poly (melamine-formaldehyde) (PMF).

Example 15 provides the microelectronic assembly according to any one of examples 12-14, where the matrix material includes a thermoset (e.g., one or more of a phenolic, an alkyd, a vinyl ester, an unsaturated polyester, a polyurethane, or an aminoplastic).

Example 16 provides the microelectronic assembly according to any one of examples 1-15, where the opening is a trench extending parallel to the edge.

Example 17 provides the microelectronic assembly according to example 16, where the trench extends from the first face to a depth that is between about 51% and 60% of a thickness of the glass core.

Example 18 provides the microelectronic assembly according to example 16, where the trench extends from the first face to a depth that is between about 60% and 80% of a thickness of the glass core.

Example 19 provides the microelectronic assembly according to any one of examples 1-15, where: the opening is a first opening, the trench is a first trench, the microelectronic assembly further includes a second opening in the edge region, the second opening extending from the second face towards the first face and including the fill material, and the second opening is a second trench extending parallel to the edge.

Example 20 provides the microelectronic assembly according to example 19, where a footprint (e.g., a projection onto the first and/or second face of the glass core) of the first trench is offset with respect to a footprint of the second trench.

Example 21 provides the microelectronic assembly according to examples 19 or 20, where the trench extends from the second face to a depth that is between about 51% and 60% of a thickness of the glass core.

Example 22 provides the microelectronic assembly according to examples 19 or 20, where the trench extends from the second face to a depth that is between about 60% and 80% of a thickness of the glass core.

Example 23 provides the microelectronic assembly according to any one of examples 16-22, where a transverse cross-sectional profile of the trench is a semi-circle.

Example 24 provides the microelectronic assembly according to any one of examples 16-22, where a transverse cross-sectional profile of the trench is an ellipse.

Example 25 provides the microelectronic assembly according to any one of examples 16-22, where a transverse cross-sectional profile of the trench is a polygon.

Example 26 provides the microelectronic assembly according to any one of examples 1-15, where the opening is one of a plurality of openings within the edge region extending parallel to the edge.

Example 27 provides the microelectronic assembly according to example 26, where an individual opening is an opening according to any one of examples 16-25.

Example 28 provides the microelectronic assembly according to any one of examples 1-15, where the opening extends between the first face and the second face.

Example 29 provides the microelectronic assembly according to example 28, where the opening is one of a plurality of openings within the edge region extending parallel to the edge.

Example 30 provides the microelectronic assembly according to example 29, where the plurality of openings are aligned at the edge.

Example 31 provides a microelectronic assembly that includes a glass core (e.g., a layer of glass including a rectangular prism volume) having a first face and a second face, where the second face is opposite the first face; and an anchor, including a first pad over the first face of the glass core, a second pad over the second face of the glass core, and a pin, where the pin is attached to the first pad and extends from the first pad into the glass core.

Example 32 provides the microelectronic assembly according to example 31, where the pin is in a blind via in the glass core (i.e., the pin does not reach the second face of the glass core).

Example 33 provides the microelectronic assembly according to example 32, where the pin extends through the glass core and is further attached to the second pad.

Example 34 provides the microelectronic assembly according to any one of examples 31-33, where the anchor includes a material having a negative CTE.

Example 35 provides the microelectronic assembly according to any one of examples 31-34, where the anchor includes an insulator material, a polymer, or ABF.

Example 36 provides the microelectronic assembly according to any one of examples 31-35, where the anchor includes a metal.

Example 37 provides the microelectronic assembly according to example 36, where the anchor is electrically isolated from all ground, signal, and power pathways.

Example 38 provides the microelectronic assembly according to any one of examples 31-37, where: the anchor is in an edge region of the glass core, and the edge region is a region between an edge of the glass core and a plane parallel to the edge, the plane being separated from the edge by a distance that is less than about 10% (e.g., less than about 5% or less than about 1%) of a width of the glass core (the width being measured in a direction that is substantially parallel to the first face and perpendicular to a line where the edge meets the first face).

Example 39 provides the microelectronic assembly according to example 38, where a dimension of the first pad in a direction perpendicular to the edge of the glass core is larger than a dimension of the pin in the direction perpendicular to the edge of the glass core.

Example 40 provides the microelectronic assembly according to example 39, where a dimension of the first pad in a direction parallel to the edge of the glass core is larger than the dimension of the first pad in the direction perpendicular to the edge of the glass core.

Example 41 provides a microelectronic assembly that includes a glass core (e.g., a layer of glass including a rectangular prism volume) having a first face and a second face, where the second face is opposite the first face; and a daisy chain structure embedded in the glass core proximate to an edge of the glass core, the daisy chain structure having first portions in recesses in the first face and having second portions in recesses in the second face.

Example 42 provides the microelectronic assembly according to example 41, where a distance between the edge and the daisy chain structure is less than about 10% (e.g., less than about 5% or less than about 1%) of a width of the glass core.

Example 43 provides the microelectronic assembly according to examples 41 or 42, where the daisy chain structure further includes third portions embedded in the glass core, where an individual third portion is connected to an end of one of the first portions and an end of one of the second portions.

Example 44 provides the microelectronic assembly according to example 43, where the third portions are substantially perpendicular to the first face.

Example 45 provides the microelectronic assembly according to example 43, where the third portions are at angles less than 90 degrees with respect to the first face.

Example 46 provides the microelectronic assembly according to any one of examples 41-45, where: the daisy chain structure is one of a plurality of daisy chain structures, the edge is one of a plurality of edges of the glass core, and the daisy chain structures are connected in a ring along the plurality of edges of the glass core.

Example 47 provides the microelectronic assembly according to any one of examples 41-46, where the daisy chain structure includes a polymer.

Example 48 provides the microelectronic assembly according to any one of examples 41-47, where the daisy chain structure includes an insulator material.

Example 49 provides the microelectronic assembly according to any one of examples 41-48, where the daisy chain structure includes ABF.

Example 50 provides the microelectronic assembly according to any one of examples 41-49, where the daisy chain structure includes a metal.

Example 51 provides a microelectronic assembly that includes a glass core (e.g., a layer of glass including a rectangular prism volume) having a first face, a second face opposite the first face, and an edge between an end of the first face and an end of the second face; and a clamp structure around the edge, the clamp structure having a first portion at the first face, a second portion at the second face, and a third portion at the edge, where the third portion is attached to the first portion and the second portion.

Example 52 provides the microelectronic assembly according to example 51, where the third portion is materially continuous with the first portion and the second portion.

Example 53 provides the microelectronic assembly according to examples 51 or 52, where the first portion extends over the first face to a distance from the edge that is less than about 10% (e.g., less than about 5% or less than about 1%) of a width of the glass core.

Example 54 provides the microelectronic assembly according to any one of examples 51-53, where the clamp structure includes a material having a negative CTE.

Example 55 provides the microelectronic assembly according to any one of examples 51-54, where the clamp structure extends along at least 50% of a length of the edge.

Example 56 provides the microelectronic assembly according to any one of examples 51-55, where the clamp structure extends along an entire length of the edge.

Example 57 provides the microelectronic assembly according to any one of examples 51-56, where: the clamp structure is one of a plurality of clamp structures, the edge is one of a plurality of edges of the glass core, the clamp structures are connected in a ring along the plurality of edges of the glass core.

Example 58 provides the microelectronic assembly according to any one of examples 51-56, where the clamp structure is one of a plurality of clamp structures around the edge.

Example 59 provides the microelectronic assembly according to example 58, where the clam structures of the plurality of clamp structures are materially discontinuous from one another.

Example 60 provides the microelectronic assembly according to any one of the preceding examples, where: the microelectronic assembly includes a glass panel including a plurality of glass cores, and the glass core is one of the plurality of glass cores.

Example 71 provides the microelectronic assembly according to any one of the preceding examples, where the glass core is a solid layer of glass.

Example 72 provides the microelectronic assembly according to any one of the preceding examples, where a cross-section of the glass core in a plane perpendicular to a surface of the component is substantially rectangular.

Example 73 provides the microelectronic assembly according to any one of the preceding examples, where a cross-section of the glass core in a plane parallel to a surface of the component is substantially rectangular.

Example 74 provides the microelectronic assembly according to any one of the preceding examples, where the glass core is a layer of glass including at least 23% silicon by weight.

Example 75 provides the microelectronic assembly according to any one of the preceding examples, where the glass core is a layer of glass including at least 26% oxygen by weight.

Example 76 provides the microelectronic assembly according to any one of the preceding examples, where the glass core is a layer of glass including at least 23% silicon by weight and at least 26% oxygen by weight.

Example 77 provides the microelectronic assembly according to any one of the preceding examples, where the glass core is a layer of glass including at least 5% aluminum by weight.

Example 78 provides the microelectronic assembly according to any one of the preceding examples, where the glass core is a layer of glass that does not include an organic adhesive or an organic material.

Example 79 provides the microelectronic assembly according to any one of the preceding examples, where the glass core is a layer of glass having a thickness in a range of 50 micron (um) to 1.4 millimeters (mm), a first length in a range of 10 mm to 250 mm, and a second length in a range of 10 mm to 250 mm, the first length perpendicular to the second length.

Example 80 provides the microelectronic assembly according to any one of the preceding examples, where the glass core is a layer of glass having a thickness in a range of 50 um to 1.4 mm.

Example 81 provides the microelectronic assembly according to any one of the preceding examples, where the glass core is a layer of glass having a first length in a range of 10 mm to 250 mm, and a second length in a range of 10 mm to 250 mm, the first length perpendicular to the second length.

Example 82 provides the microelectronic assembly according to any one of the preceding examples, where the glass core is a layer of glass including a rectangular prism volume.

Example 83 provides the microelectronic assembly according to any one of the preceding examples, where the glass core is a layer of glass including a rectangular prism volume having a first side and a second side perpendicular to the first side, the first side having a length in a range of 10 mm to 250 mm and the second side having a length in a range of 10 mm to 250 mm.

Example 84 provides the microelectronic assembly according to any one of the preceding examples, where the glass core is a layer of glass including a rectangular prism volume and a via extending from a first side of the rectangular prism volume to a second side of the rectangular prism volume, the via including a metal.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a glass core having a first face, a second face opposite the first face, an edge between an end of the first face and an end of the second face, and an edge region extending from the edge into the glass core by a distance that is less than about 10% of a width of the glass core; and
an opening in the edge region, the opening extending from the first face towards the second face and comprising a fill material.

2. The microelectronic assembly according to claim 1, wherein the fill material includes an inorganic insulator material.

3. The microelectronic assembly according to any one of the preceding claims, wherein the fill material includes a polymer.

4. The microelectronic assembly according to any one of the preceding claims, wherein a Young's modulus of the fill material is smaller than about 10 gigapascal.

5. The microelectronic assembly according to any one of the preceding claims, wherein the fill material includes a metal, wherein the metal is electrically isolated from all signal pathways, ground pathways, and power pathways in the microelectronic assembly.

6. The microelectronic assembly according to any one of the preceding claims, wherein the fill material includes a matrix material and particles dispersed in the matrix material, the particles containing poly(urea-formaldehyde), polyurethane, poly(melamine-urea-formaldehyde), or poly(melamine-formaldehyde).

7. The microelectronic assembly according to claim 6, wherein the fill material or the glass core includes ruthenium.

8. The microelectronic assembly according to any one of the preceding claims, wherein the opening is a trench extending parallel to the edge.

9. The microelectronic assembly according to claim 8, wherein:
the opening is a first opening,
the trench is a first trench,
the microelectronic assembly further includes a second opening in the edge region, the second opening extending from the second face towards the first face and comprising the fill material, and
the second opening is a second trench extending parallel to the edge, wherein a footprint of the first trench is offset with respect to a footprint of the second trench.

10. The microelectronic assembly according to any one of the preceding claims, wherein the opening extends between the first face and the second face, the opening is one of a plurality of openings within the edge region extending parallel to the edge, and the plurality of openings are aligned at the edge.

11. A microelectronic assembly, comprising:
a glass core having a first face and a second face, wherein the second face is opposite the first face; and
a daisy chain structure embedded in the glass core proximate to an edge of the glass core, the daisy chain structure comprising a polymer and having first portions in recesses in the first face and having second portions in recesses in the second face.

12. The microelectronic assembly according to claim 11, wherein:
the daisy chain structure is one of a plurality of daisy chain structures,
the edge is one of a plurality of edges of the glass core, and
the daisy chain structures are connected in a ring along the plurality of edges of the glass core.
